(19) Europäisches Patentamt
European Patent Office
Office européen des brevets

(11) EP 4 098 702 A1

(12) EUROPEAN PATENT APPLICATION
published in accordance with Art. 153(4) EPC

(43) Date of publication:
**07.12.2022 Bulletin 2022/49**

(21) Application number: **21747640.7**

(22) Date of filing: **28.01.2021**

(51) International Patent Classification (IPC):
***C08L 101/12*** *(2006.01)* ***G03F 7/20*** *(2006.01)*
***H01B 1/20*** *(2006.01)* ***H01L 21/027*** *(2006.01)*

(52) Cooperative Patent Classification (CPC):
**C08L 101/12; G03F 7/20; H01B 1/20; H01L 21/027**

(86) International application number:
**PCT/JP2021/003062**

(87) International publication number:
**WO 2021/153678 (05.08.2021 Gazette 2021/31)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **29.01.2020 JP 2020012623**

(71) Applicant: **Mitsubishi Chemical Corporation**
**Chiyoda-ku**
**Tokyo 100-8251 (JP)**

(72) Inventors:
- **NAKANO Saki**
  **Tokyo 100-8251 (JP)**
- **MORI Takahiro**
  **Tokyo 100-8251 (JP)**

(74) Representative: **Hoffmann Eitle**
**Patent- und Rechtsanwälte PartmbB**
**Arabellastraße 30**
**81925 München (DE)**

# (54) CONDUCTIVE COMPOSITE, RESIST COATING MATERIAL, RESIST, AND RESIST PATTERN FORMATION METHOD

(57) There is provided a conductive composite having excellent conductivity and able to form a conductive film with which film loss in a resist layer is low. The conductive composite of the present invention includes a conductive polymer and a surfactant. When a critical micelle concentration of the surfactant is less than 0.1% by mass, a content of the surfactant is 5 parts by mass or more with respect to 100 parts by mass of the conductive polymer. In addition, when the critical micelle concentration of the surfactant is 0.1% by mass or more, the content of the surfactant is more than 100 parts by mass with respect to 100 parts by mass of the conductive polymer.

EP 4 098 702 A1

## Description

[Technical Field]

The present invention relates to a conductive composite, a resist coating material, a resist, and a method for forming a resist pattern.

Priority is claimed on Japanese Patent Application No. 2020-012623 filed on January 29, 2020, the content of which is incorporated herein by reference.

[Background Art]

Pattern forming techniques using charged particle beams, such as electron beams and ion beams, are expected to be the next-generation techniques for optical lithography. When using charged particle beams, it is important to improve the sensitivity of the resist layer to increase productivity.

Accordingly, the use of highly sensitive chemically amplified resist layers has become mainstream, in which an acid is generated in an exposed portion or a portion irradiated with charged particle beams and then a cross-linking reaction or a decomposition reaction is advanced by a heat treatment known as a post-exposure bake (PEB) treatment.

In addition, in recent years, the movement toward miniaturization of semiconductor devices has also led to a demand for resist shape management on the order of several nm.

Here, in pattern forming methods using charged particle beams, in particular, when the substrate has an insulating property, there is a problem in that the electric field generated by the charging (charge-up) of the substrate causes the trajectory of the charged particle beam to bend, making it difficult to obtain the desired pattern.

As a means of solving this problem, a technique is known in which a conductive composite including a conductive polymer is coated on the surface of the resist layer to form a conductive film and the surface of the resist layer is covered with the conductive film.

Conductive polymers having acid groups are known as conductive polymers. It is possible for conductive polymers having acid groups to develop conductivity without the addition of doping agents.

Conductive polymers having acid groups are obtained, for example, by polymerizing aniline having acid groups using an oxidizing agent in the presence of a basic compound such as trimethylamine or pyridine (refer to, for example, Patent Document 1).

In a method for polymerizing acid group-substituted anilines in the presence of a basic compound, some of the acid groups in the polyanilines, unreacted monomers, and oligomers accompanying the resulting side reactions tend to form salts with the basic compounds.

However, the basic compound is not able to stably neutralize the acid groups of polyaniline due to the physical properties thereof such as the base strength, thus, the acid groups in polyaniline tend to undergo hydrolysis or the like and are unstable. Therefore, after coating polyaniline on the resist layer, the acid groups are easily eliminated when forming a conductive film by carrying out a heat treatment. In addition, the oxidizing agent used during polymerization may be decomposed to generate sulfate ions or the like. As a result, the eliminated acid groups and decomposition products of the oxidizing agent may migrate to the resist layer, dissolving the resist layer in an unexposed portion during development and causing film loss of the resist layer or the like.

Therefore, a method was proposed in which polyaniline obtained by polymerization of acid group-substituted aniline with an oxidizing agent in the presence of a basic compound is subjected to a desalting treatment by ion exchange, electrodialysis, or the like to remove basic compounds and the like and then a basic compound which is a strong base is newly added thereto (refer to, for example, Patent Document 2).

In addition, it is also known that a surfactant is blended into a conductive composite for the purpose of improving the coating property when the conductive composite including the conductive polymer described above is coated on the surface of a resist layer (refer to, for example, Patent Document 3).

[Citation List]

[Patent Documents]

[Patent Document 1]
Japanese Unexamined Patent Application, First Publication No. H7-324132
[Patent Document 2]
Japanese Unexamined Patent Application, First Publication No. 2011-219680

[Patent Document 3]
Japanese Unexamined Patent Application, First Publication No. 2017-171940

[Summary of Invention]

[Technical Problem]

According to the method described in Patent Document 2, the newly added basic compound forms a stable salt with some of the acid groups of polyaniline, thus, it is possible to stabilize the acid group portion of polyaniline and to suppress the elimination of the acid groups from polyaniline. In addition, the newly added basic compound also tends to form salts with decomposition products of oxidizing agents. Thus, it is difficult for acid groups and decomposition products of oxidizing agents to migrate into the resist layer and it is possible to suppress film loss of the resist layer.
However, there is still room for improvement in the prevention of film loss of the resist layer and there is a demand for further improvement in the prevention of film loss.
In addition, it is known that conductive composites in which surfactants are blended have a trade-off relationship between the coating property and the influence on the resist layer and the conductive composites described in Patent Document 3 were not necessarily at a sufficient level in terms of the prevention of film loss.
The present invention has an object of providing a conductive composite, a resist coating material, a resist, and a method for forming a resist pattern, which are able to form a conductive film having excellent conductivity and with which film loss in a resist layer is low.

[Solution to Problem]

The present invention has the following aspects.

[1] A conductive composite including a conductive polymer, and a surfactant, in which a critical micelle concentration of the surfactant is less than 0.1% by mass and a content of the surfactant is 5 parts by mass or more with respect to 100 parts by mass of the conductive polymer.
[2] The conductive composite according to [1], in which the content of the surfactant is 10 parts by mass or more with respect to 100 parts by mass of the conductive polymer.
[3] A conductive composite including a conductive polymer, and a surfactant, in which a critical micelle concentration of the surfactant is 0.1% by mass or more and a content of the surfactant is more than 100 parts by mass with respect to 100 parts by mass of a content of the conductive polymer.
[4] The conductive composite according to [3], in which the content of the surfactant is 110 parts by mass or more with respect to 100 parts by mass of the conductive polymer.
[5] The conductive composite according to any one of [1] to [4], in which the surfactant is a water-soluble polymer having a terminal hydrophobic group.
[6] The conductive composite according to any one of [1] to [5], further including a basic compound.
[7] The conductive composite according to [6], in which an acid dissociation constant of the basic compound at 25°C is 13 or more, a molecular weight of the basic compound is 200 or less, and a content of the basic compound is 1 to 50 parts by mass with respect to 100 parts by mass of the conductive polymer.
[8] The conductive composite according to any one of [1] to [7], in which the conductive polymer has an acid group.
[9] The conductive composite according to any one of [1] to [8], in which a surface resistivity is $1 \times 10^{10}$ [Ω/sq] or less.
[10] A resist coating material including the conductive composite according to any one of [1] to [9].
[11] A resist, in which a conductive film including the conductive composite according to any one of [1] to [9] is formed on a surface.
[12] A method for forming a resist pattern, the method including a laminating step of forming a conductive film including the conductive composite according to any one of [1] to [9] on a surface of a resist layer of a substrate having the resist layer formed of a chemically amplified resist on one side, and an exposure step of irradiating the substrate on which the conductive film is formed with a charged particle beam in a pattern shape from a conductive film side.

[Advantageous Effects of Invention]

According to the present invention, it is possible to provide a conductive composite, a resist coating material, a resist, and a method for forming a resist pattern, which are able to form a conductive film having excellent conductivity and with which film loss in a resist layer is low.

[Description of Embodiments]

A detailed description will be given below of the present invention. The following embodiments are mere examples to illustrate the present invention and are not intended to limit the present invention only to the embodiments. It is possible to realize the present invention in various aspects which do not depart from the gist thereof.

In the present invention, "conductivity" means having a surface resistivity of 1 x $10^{11}$ Ω/sq or less. Surface resistivity is determined from the potential difference between electrodes when a constant current flows therethrough.

In the present specification, "solubility" means uniform dissolution of 0.1 g or more in 10 g (at a liquid temperature of 25°C) of one or more of the solvents including water, water including at least one of a base and a basic salt, water including an acid, or a mixture of water and a water-soluble organic solvent. In the present specification, "water-soluble" means having the solubility described above with respect to water.

In the present specification, the "terminal" of the "terminal hydrophobic group" means a moiety other than the repeating unit forming the polymer.

In the present specification, "mass average molecular weight" means the mass average molecular weight (sodium polystyrene sulfonate equivalent or polyethylene glycol equivalent) measured by gel permeation chromatography (GPC).

In the present specification, a numerical value range represented using "to" means a range including the numerical values listed before and after "to" as the lower limit value and the upper limit value.

[Conductive Composite]

The conductive composite of the present invention includes a conductive polymer (also referred to below as "conductive polymer (A)") and a surfactant (also referred to below as "surfactant (B)"). The conductive composite of the present invention may include, for example, one or more optional components including a solvent (also referred to below as "solvent (C)") and a basic compound (also referred to below as "basic compound (D)"), as necessary.

<Conductive Polymer (A)>

As the conductive polymer (A), it is possible to use known polymers. Examples thereof include polypyrrole, polythiophene, polythiophenevinylene, polyterlophene, polyphenylene, polyphenylenevinylene, polyaniline, polyacene, and polyacetylene.

Among the above, polypyrrole, polythiophene, and polyaniline are preferable from the viewpoint of excellent conductivity.

The conductive polymer (A) is preferably water-soluble or water dispersible. When the conductive polymer (A) is water-soluble or water dispersible, the coating property of the conductive composite is improved and conductive bodies with uniform thickness are easily obtained.

The conductive polymer (A) preferably has an acid group. Having an acid group increases water solubility. Sulfonic acid groups or carboxy groups are preferable as acid groups. In one molecule, there may be only one kind of acid group or there may be two or more kinds of acid groups. Some or all of the acid groups may form salts.

As the conductive polymers (A) having acid groups, for example, the conductive polymers shown in Japanese Unexamined Patent Application, First Publication No. S61-197633, Japanese Unexamined Patent Application, First Publication No. S63-39916, Japanese Unexamined Patent Application, First Publication No. H1-301714, Japanese Unexamined Patent Application, First Publication No. H5-504153, Japanese Unexamined Patent Application, First Publication No. H5-503953, Japanese Unexamined Patent Application, First Publication No. H4-32848, Japanese Unexamined Patent Application, First Publication No. H4-328181, Japanese Unexamined Patent Application, First Publication No. H6-145386, Japanese Unexamined Patent Application, First Publication No. H6-56987, Japanese Unexamined Patent Application, First Publication No. H5-226238, Japanese Unexamined Patent Application, First Publication No. H5-178989, Japanese Unexamined Patent Application, First Publication No. H6-293828, Japanese Unexamined Patent Application, First Publication No. H7-118524, Japanese Unexamined Patent Application, First Publication No. H6-32845, Japanese Unexamined Patent Application, First Publication No. H6-87949, Japanese Unexamined Patent Application, First Publication No. H6-256516, Japanese Unexamined Patent Application, First Publication No. H7-41756, Japanese Unexamined Patent Application, First Publication No. H7-48436, Japanese Unexamined Patent Application, First Publication No. H4-268331, Japanese Unexamined Patent Application, First Publication No. 2014-65898 are preferable from the viewpoint of solubility.

Examples of the conductive polymer (A) include π-conjugated conductive polymers including at least one repeating unit selected from the group consisting of phenylene vinylene, vinylene, thienylene, pyrrolylene, phenylene, iminophenylene, isothianaphtene, furylene, and carbazolylen in each of which the α-position or β-position is substituted with at least one group selected from the group consisting of a sulfonic acid group and a carboxy group.

When the π-conjugated conductive polymer includes at least one repeating unit selected from the group consisting of iminophenylene and carbazolylen in each of which the α-position or β-position is substituted with at least one group selected from the group consisting of a sulfonic acid group and a carboxy group, examples thereof include π-conjugated conductive polymers having at least one group selected from the group consisting of a sulfonic acid group and a carboxy group on the nitrogen atom of the repeating unit, π-conjugated conductive polymers having an alkyl group substituted with at least one group selected from the group consisting of a sulfonic acid group and a carboxy group on the nitrogen atom of the repeating unit, and π-conjugated conductive polymers having an alkyl group including an ether bond substituted with at least one group selected from the group consisting of a sulfonic acid group and a carboxy group on the nitrogen atom of the repeating unit.

Among the above, from the viewpoint of conductivity and solubility, π-conjugated conductive polymers including at least one repeating unit selected from the group consisting of phenylene vinylene, thienylene, pyrrolylene, iminophenylene, isothianaphtene, and carbazolylen, in which the β-position is substituted with at least one group selected from the group consisting of a sulfonic acid group and a carboxy group are preferable.

From the viewpoint of being able to express high conductivity and solubility, in the conductive polymer (A), 20 to 100 mol% of the total units (100 mol%) forming the conductive polymer is preferably a repeating unit represented by any one of General Formulas (1) to (4).

[Chem. 1]

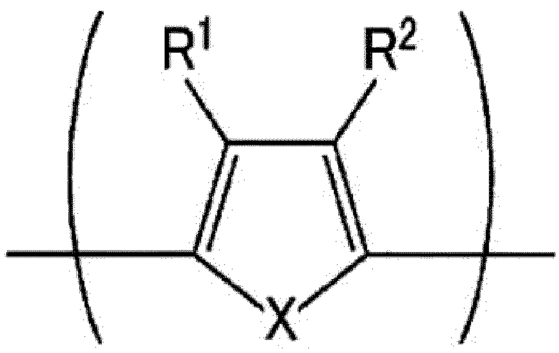

· · · (1)

[Chem. 2]

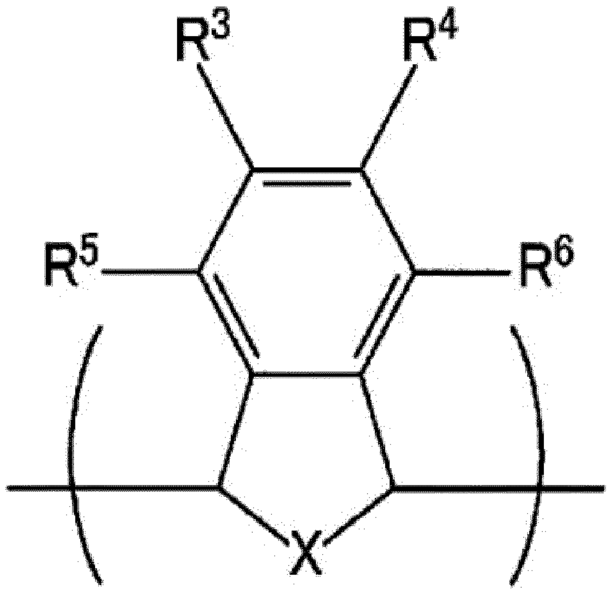

· · · (2)

[Chem. 3]

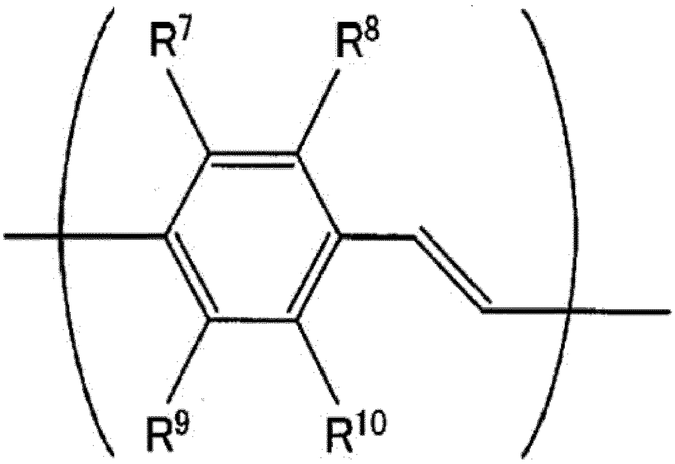

· · · (3)

[Chem. 4]

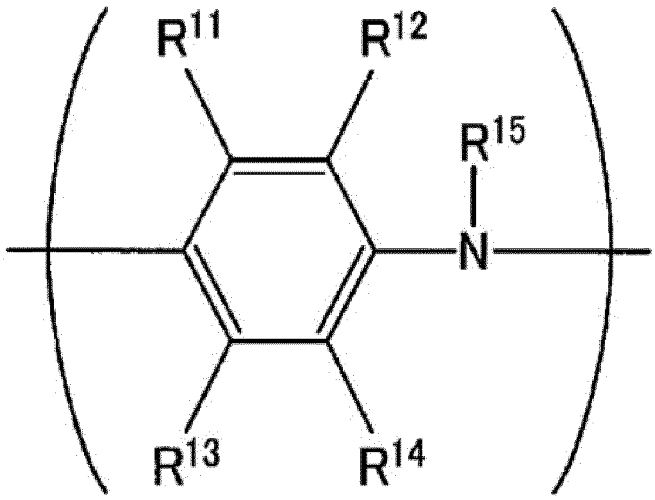

· · · (4)

In Formulae (1) to (4),

X represents a sulfur atom or nitrogen atom, and
$R^1$ to $R^{15}$ each independently represent a hydrogen atom, a linear or branched-chain alkyl group with 1 to 24 carbon atoms, a linear or branched-chain alkoxy group with 1 to 24 carbon atoms, an acid group, a hydroxy group, a nitro group, a halogen atom (-F, -Cl, -Br, or -I), $-N(R^{16})_2$, $-NHCOR^{16}$, $-SR^{16}$, $-OCOR^{16}$, $-COOR^{16}$, $-COR^{16}$, -CHO, or - CN. $R^{16}$ represents an alkyl group with 1 to 24 carbon atoms, an aryl group with 6 to 24 carbon atoms, or an aralkyl group with 7 to 24 carbon atoms.

Here, at least one of $R^1$ and $R^2$ of General Formula (1), at least one of $R^3$ to $R^6$ of General Formula (2), at least one of $R^7$ to $R^{10}$ of General Formula (3), and at least one of $R^{11}$ to $R^{15}$ of General Formula (4) is an acid group or salt thereof, respectively.

Here, "acid group" means a sulfonic acid group (sulfo group) or a carboxylic acid group (carboxy group).

Sulfonic acid groups may be included in a free acid state ($-SO_3H$) or may be included in an ionic state ($-SO_3-$). Furthermore, the sulfonic acid group also includes a substituent having a sulfonic acid group ($-R^{17}SO_3H$).

On the other hand, carboxylic acid groups may be included in a free acid state (-COOH) or may be included in an ionic state (-COO-). Furthermore, the carboxylic acid group also includes a substituent having a carboxylic acid group ($-R^{17}COOH$).

$R^{17}$ represents a linear or branched-chain alkylene group with 1 to 24 carbon atoms, a linear or branched-chain

arylene group with 6 to 24 carbon atoms, or a linear or branched-chain aralkylene group with 7 to 24 carbon atoms.

Examples of salts of acid groups include alkali metal salts, alkaline earth metal salts, ammonium salts, or substituted ammonium salts, of sulfonic acid groups or carboxylic acid groups.

Examples of alkali metal salts include lithium sulfate, lithium carbonate, lithium hydroxide, sodium sulfate, sodium carbonate, sodium hydroxide, potassium sulfate, potassium carbonate, potassium hydroxide, and derivatives having skeletons thereof.

Examples of alkaline earth metal salts include magnesium salts and calcium salts.

Examples of substituted ammonium salts include aliphatic ammonium salts, saturated alicyclic ammonium salts, and unsaturated alicyclic ammonium salts.

Examples of aliphatic ammonium salts include methyl ammonium, dimethyl ammonium, trimethyl ammonium, ethyl ammonium, diethyl ammonium, triethyl ammonium, methyl ethyl ammonium, diethyl methyl ammonium, dimethyl ethyl ammonium, propylammonium, dipropylammonium, isopropylammonium, diisopropylammonium, butylammonium, dibutylammonium, methylpropylammonium, ethylpropylammonium, methylisopropylammonium, ethylisopropylammonium, methylbutylammonium, ethylbutylammonium, tetramethylammonium, tetramethylolammonium, tetraethylammonium, tetra n-butylammonium, tetra sec-butylammonium, and tetra t-butylammonium.

Examples of saturated alicyclic ammonium salts include piperidinium, pyrrolidinium, morpholinium, piperazinium, and derivatives having skeletons thereof.

Examples of unsaturated alicyclic ammonium salts include pyridinium, $\alpha$-picolinium, $\beta$-picolinium, $\gamma$-picolinium, quinolinium, isoquinolinium, pyrrolinium, and derivatives having skeletons thereof.

As the conductive polymer (A), from the viewpoint of being able to express high conductivity, it is preferable to have a repeating unit represented by General Formula (4). Among the above, from the viewpoint of also having excellent solubility, it is more preferable to have a repeating unit represented by General Formula (5).

[Chem. 5]

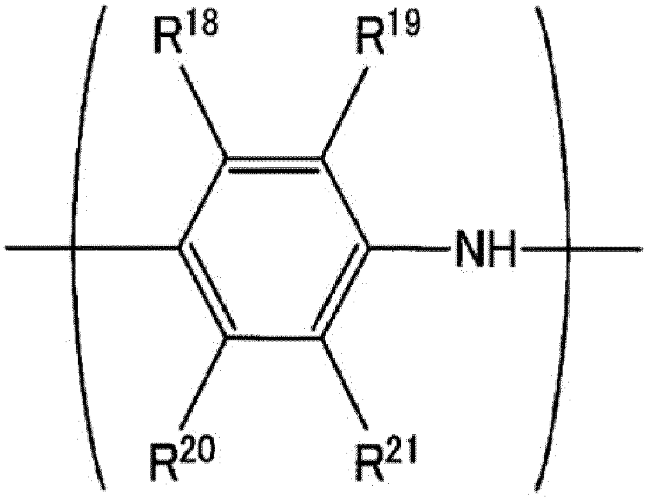

· · · (5)

In Formula (5),

$R^{18}$ to $R^{21}$ each independently represent a hydrogen atom, a linear or branched-chain alkyl group with 1 to 24 carbon atoms, a linear or branched-chain alkoxy group with 1 to 24 carbon atoms, an acid group, a hydroxy group, a nitro group, or a halogen atom (-F, -Cl, -Br, or -I).

However, at least one of $R^{18}$ to $R^{21}$ is an acid group or salt thereof.

As the repeating unit represented by General Formula (5), in terms of ease of production, preferably, among $R^{18}$ to $R^{21}$, any one is a linear or branched-chain alkoxy group with 1 to 4 carbon atoms, any other one is a sulfonic acid group, and the remainder are hydrogen atoms.

From the viewpoint of excellent solubility in water and organic solvents regardless of pH, in the conductive polymer (A), in the total number of units (100 mol%) forming the conductive polymer (A), the content of the repeating units represented by General Formula (5) is preferably 10 to 100 mol%, more preferably 50 to 100 mol%, even more preferably 90 to 100 mol%, and particularly preferably 100 mol%.

The conductive polymer (A) preferably contains 10 or more units represented by General Formula (5) in one molecule from the viewpoint of excellent conductivity.

In the conductive polymer (A), from the viewpoint of further improving the solubility, the number of aromatic rings to which an acid group is bonded is preferably 50% or more with respect to the total number of aromatic rings in the polymer, more preferably 70% or more, even more preferably 80% or more, particularly preferably 90% or more, and most preferably 100%.

The number of aromatic rings to which the acid group is bonded with respect to the total number of aromatic rings in the polymer is calculated from the monomer charging ratio during the production of the conductive polymer (A).

In the conductive polymer (A), from the viewpoint of providing reactivity to the monomer, substituents other than acid groups on the aromatic ring of the repeating unit are preferably electron-donating groups.

For example, an alkyl group with 1 to 24 carbon atoms, an alkoxy group with 1 to 24 carbon atoms, and a halogen group (-F, -Cl, -Br, or -I) are preferable. Among these, an alkoxy group with 1 to 24 carbon atoms is most preferable from the viewpoint of electron donating.

The conductive polymer (A) may include one or more repeating units selected from the group consisting of substituted or unsubstituted aniline, thiophene, pyrrole, phenylene, vinylene, divalent unsaturated groups, and divalent saturated groups as repeating units other than the repeating units represented by General Formula (5), as long as the solubility, conductivity, and properties thereof are not influenced.

From the viewpoint of being able to express high conductivity and solubility, the conductive polymer (A) is preferably a compound having the structure represented by General Formula (6) and, among compounds having the structure represented by General Formula (6), poly(2-sulfo-5-methoxy-1,4-iminophenylene) is particularly preferable.

[Chem. 6]

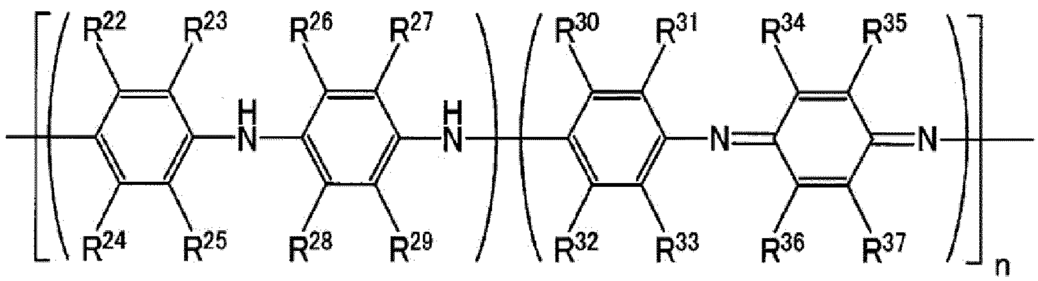

· · · (6)

In Formula (6),

$R^{22}$ to $R^{37}$ each independently represent a hydrogen atom, a linear or branched-chain alkyl group with 1 to 4 carbon atoms, a linear or branched-chain alkoxy group with 1 to 4 carbon atoms, an acid group, a hydroxy group, a nitro group, or a halogen atom (-F, -Cl, -Br or -I).

Here, at least one of $R^{22}$ to $R^{37}$ is an acid group or salt thereof.

n is an integer from 5 to 2500.

From the viewpoint of improving conductivity, the acid groups contained in the conductive polymer (A) are preferably at least partially a free acid type.

The mass average molecular weight of the conductive polymer (A), in terms of GPC sodium polystyrene sulfonate equivalent, is preferably 1,000 to 1,000,000, more preferably 1,500 to 800,000, even more preferably 2,000 to 500,000, and particularly preferably 2,000 to 100,000 from the viewpoint of the conductivity, solubility, and film forming properties thereof.

When the mass average molecular weight of the conductive polymer (A) is less than 1000, the solubility is excellent, but the conductivity and film forming properties may be lacking. On the other hand, when the mass average molecular weight exceeds 1,000,000, the conductivity is excellent, but the solubility may be insufficient.

Here, "film forming properties" refers to the property of forming a uniform film with no cissing and for which evaluation is possible, for example, by spin coating on glass.

The conductive polymer (A) is obtained, for example, by polymerizing the raw material monomer of the conductive polymer (A) in the presence of a polymerization solvent and an oxidizing agent.

A description will be given below of an example of a method for producing the conductive polymer (A).

(Method for Producing Conductive Polymer (A))

The method of producing conductive polymer (A) includes a step of polymerizing raw material monomers of the conductive polymer (A) in the presence of a polymerization solvent and an oxidizing agent (polymerization step). The method for producing the conductive polymer (A) may include a step of purifying the reaction product obtained in the polymerization step (purifying step).

<Polymerization Step>

The polymerization step is a step of polymerizing the raw material monomer of the conductive polymer (A) in the presence of a polymerization solvent and an oxidizing agent.

Examples of the raw material monomers include the polymerizable monomers from which the repeating units described above are derived, for example, at least one type selected from the group consisting of an acid group-substituted aniline; alkali metal salts, alkaline earth metal salts, ammonium salts, and substituted ammonium salts of the acid group-substituted anilines..

Examples of the acid group-substituted aniline include a sulfonic acid group-substituted aniline having a sulfonic acid group as an acid group.

Examples of sulfonic acid group-substituted anilines include aminobenzenesulfonic acids. Examples of aminobenzenesulfonic acids include o-aminobenzenesulfonic acid, m-aminobenzenesulfonic acid, p-aminobenzenesulfonic acid, aniline-2,6-disulfonic acid, aniline-2,5-disulfonic acid, aniline-3,5-disulfonic acid, aniline-2,4-disulfonic acid, and aniline-3,4-disulfonic acid.

Examples of sulfonic acid group-substituted anilines other than aminobenzenesulfonic acids include alkyl group-substituted aminobenzenesulfonic acids such as methylaminobenzenesulfonic acid, ethylaminobenzenesulfonic acid, n-propylaminobenzenesulfonic acid, iso-propylaminobenzenesulfonic acid, n-butylaminobenzenesulfonic acid, sec-butylaminobenzenesulfonic acid, and t-butylaminobenzenesulfonic acid; alkoxy group-substituted aminobenzenesulfonic acids such as methoxyaminobenzenesulfonic acid, ethoxyaminobenzenesulfonic acid, and propoxyaminobenzenesulfonic acid; hydroxy group-substituted aminobenzenesulfonic acids; nitro group-substituted aminobenzenesulfonic acids; and halogen-substituted aminobenzenesulfonic acids such as fluoroaminobenzenesulfonic acid, chloroaminobenzenesulfonic acid, and bromoaminobenzenesulfonic acid.

Among the above, in terms of obtaining the conductive polymer (A) with particularly excellent conductivity and solubility, alkyl group-substituted aminobenzenesulfonic acids, alkoxy group-substituted aminobenzenesulfonic acids, hydroxy group-substituted aminobenzenesulfonic acids, and halogen-substituted aminobenzenesulfonic acids are preferable. Furthermore, in terms of the ease of production, alkoxy group-substituted aminobenzenesulfonic acids and alkali metal salts, ammonium salts, and substituted ammonium salts of alkoxy group-substituted aminobenzenesulfonic acids are particularly preferable.

Any one of these sulfonic acid group-substituted anilines may be used alone or two or more may be used together in any ratio.

Examples of polymerization solvents include water, organic solvents, and mixed solvents of water and organic solvents.

Examples of water include tap water, ion-exchanged water, pure water, and distilled water.

Examples of organic solvents include alcohols such as methanol, ethanol, isopropyl alcohol, propyl alcohol, and butanol; ketones such as acetone and ethyl isobutyl ketone; ethylene glycols such as ethylene glycol and ethylene glycol methyl ether; propylene glycols such as propylene glycol, propylene glycol methyl ether, propylene glycol ethyl ether, propylene glycol butyl ether, and propylene glycol propyl ether; amides such as N,N-dimethylformamide and N,N-dimethylacetamide; and pyrrolidones such as N-methylpyrrolidone and N-ethylpyrrolidone.

As the polymerization solvent, water or a mixed solvent of water and an organic solvent is preferable.

When a mixed solvent of water and an organic solvent is used as the polymerization solvent, the mass ratio (water/organic solvent) is preferably 1/100 to 100/1 and more preferably 2/100 to 100/2.

The oxidizing agent is not limited beyond being any oxidizing agent with a standard electrode potential of 0.6 V or higher. Examples include peroxodisulfates such as peroxodisulfuric acid, ammonium peroxodisulfate, sodium peroxodisulfate, and potassium peroxodisulfate; and hydrogen peroxide.

Any one of these oxidizing agents may be used alone or two or more may be used together in any ratio.

In addition to the polymerization solvent and oxidizing agent, in the polymerization step, the raw material monomer may be polymerized in the presence of a basic reaction aid.

Examples of basic reaction aids include inorganic bases such as sodium hydroxide, potassium hydroxide, and lithium hydroxide; ammonia; fatty amines such as methylamine, dimethylamine, trimethylamine, ethylamine, diethylamine, triethylamine, ethyl methylamine, ethyl dimethylamine, and diethyl methylamine; cyclic saturated amines; cyclic unsaturated amines such as pyridine, $\alpha$-picoline, $\beta$-picoline, $\gamma$-picoline, and quinoline.

Among the above, inorganic bases, fatty amines, and cyclic unsaturated amines are preferable and cyclic unsaturated amines are more preferable.

Any one of these basic reaction aids may be used alone or two or more may be used together in any ratio.

Examples of polymerization methods include a method of dropping a raw material monomer solution into an oxidizing agent solution, a method of dropping an oxidizing agent solution into a raw material monomer solution, and a method of dropping a raw material monomer solution and an oxidizing agent solution simultaneously into a reaction container. The raw material monomer solution may include a basic reaction aid as necessary.

As solvents for the oxidizing agent solution and the raw material monomer solution, it is possible to use the polymerization solvents described above.

The reaction temperature for the polymerization reaction is preferably 50°C or lower, more preferably -15 to 30°C, and even more preferably -10 to 20°C. When the reaction temperature of the polymerization reaction is 50°C or lower, in particular, 30°C or lower, it is possible to prevent the progress of side reactions and decreases in conductivity due to changes in the redox structure of the main chain of the generated conductive polymer (A). When the reaction temperature of the polymerization reaction is -15°C or higher, it is possible to maintain a sufficient reaction rate and shorten the reaction time.

Through the polymerization step, the conductive polymer (A), which is the reaction product, is obtained in a state of being dissolved or precipitated in the polymerization solvent.

When the reaction product is dissolved in the polymerization solvent, the polymerization solvent is distilled off to obtain the reaction product.

When the reaction product is precipitated in the polymerization solvent, the polymerization solvent is filtered out by a filter such as a centrifuge to obtain the reaction product.

In the reaction products, low molecular weight components such as unreacted raw material monomers, oligomers accompanying the resulting side reactions, acidic substances (free acid groups eliminated from the conductive polymer (A), sulfate ions which are decomposition products of oxidizing agents, and the like), and basic substances (basic reaction aids, ammonium ions which are decomposition products of oxidizing agents, and the like) may be included. These low molecular weight components are impurities and are a factor which interfere with the conductivity.

Thus, it is preferable to purify the reaction product to remove the low molecular weight components.

<Purification Step>

The purification step is a step of purifying the reaction product obtained in the polymerization step.

As a method for purifying the reaction product, for example, it is possible to use a washing method using a washing solvent, a membrane filtration method, an ion exchange method, removal of impurities by a heat treatment, and neutralization precipitation. Among the above, from the viewpoint of being able to easily obtain the conductive polymer (A) with a high purity, the washing method and ion exchange method are preferable. In particular, from the viewpoint of being able to efficiently remove raw material monomers, oligomers, acidic substances, and the like, the washing method is preferable. From the viewpoint of being able to efficiently remove basic substances present in a state where a salt is formed with the acid groups of the conductive polymer (A), the ion exchange method is preferable. In the purification step, a combination of the washing method and the ion exchange method may be used.

Examples of washing solvents include alcohols such as methanol, ethanol, n-propanol, isopropanol, n-butanol, isobutanol, 2-butanol, 3-butanol, t-butanol, 1-pentanol, 3-methyl-1-butanol, 2-pentanol, n-hexanol, 4-methyl-2-pentanol, 2-ethylbutynol, benzyl alcohol, furfuryl alcohol, and tetrahydrofurfuryl alcohol; polyhydric alcohol derivatives such as ethylene glycol monomethyl ether, ethylene glycol monoethyl ether, methoxy methoxyethanol, propylene glycol monoethyl ether, and glyceryl monoacetate; acetone, acetonitrile, N,N-dimethylformamide, N-methylpyrrolidone, and dimethyl sulfoxide. Among the above, methanol, ethanol, isopropanol, acetone, and acetonitrile are preferable.

When the reaction product after washing, that is, the conductive polymer (A) after washing is dried, the conductive polymer (A) in solid form is obtained.

Examples of ion exchange methods include column type or batch type treatments using ion exchange resins such as cation exchange resins and anion exchange resins; and electrodialysis methods.

When the reaction product is dissolved in the polymerization solvent, the contact may be carried out with the ion exchange resin as it is in the dissolved state. When the concentration of the reaction product is high, dilution may be carried out with an aqueous medium.

When the reaction product is precipitated in the polymerization solvent, preferably, a polymer solution, in which the reaction product is dissolved in an aqueous medium to the desired solid concentration after removal of the polymerization solvent by filtration, is prepared and brought into contact with the ion exchange resin.

When the reaction product after washing is subjected to ion exchange treatment, preferably, a polymer solution, in which the reaction product after washing is dissolved in an aqueous medium to the desired solid concentration, is prepared and brought into contact with the ion exchange resin.

Examples of the aqueous medium include the solvent (C) described below.

As the concentration of the conductive polymer (A) in the polymer solution, from the viewpoint of industrial efficiency and purification efficiency, 0.1 to 20% by mass is preferable and 0.1 to 10% by mass is more preferable.

In the case of an ion exchange method using an ion exchange resin, for the amount of the sample solution with respect to the ion exchange resin, for example, in a case of a polymer solution with a solid concentration of 5% by mass, up to 10 times the volume with respect to the ion exchange resin is preferable and up to 5 times the volume is more preferable. Examples of the cation exchange resin include "Amberlite IR-120B" manufactured by Organo Corporation. Examples of the anion exchange resin include "Amberlite IRA410" manufactured by Organo Corporation.

The conductive polymer (A) after ion exchange treatment is in a state of being dissolved in the polymerization solvent or aqueous medium. Accordingly, when all of the polymerization solvent or aqueous medium is removed by an evaporator or the like, the solid conductive polymer (A) is obtained, but the conductive polymer (A) may be used for the production of conductive composites in a dissolved state in a polymerization solvent or an aqueous medium.

<Surfactant (B)>

Examples of the surfactant (B) include anionic surfactants, cationic surfactants, amphoteric surfactants, non-ionic surfactants, and the like. Any one of these surfactants may be used alone or two or more may be used together in any ratio.

Examples of anionic surfactants include sodium dialkylsulfosuccinate, sodium octanoate, sodium decanoate, sodium laurate, sodium myristate, sodium palmitate, sodium stearate, perfluorononanoic acid, sodium N-lauroyl sarcosine, sodium cocoyl glutamate, alpha sulfo fatty acid methyl ester salts, sodium lauryl sulfate, sodium myristyl sulfate, sodium laureth sulfate, sodium polyoxyethylene alkyl phenol sulfonate, ammonium lauryl sulfate, lauryl phosphate, sodium lauryl phosphate, and potassium lauryl phosphate.

Examples of cationic surfactants include tetramethylammonium chloride, tetramethylammonium hydroxide, tetrabutylammonium chloride, dodecyldimethylbenzylammonium chloride, alkyltrimethylammonium chloride, octyltrimethylammonium chloride, decyltrimethylammonium chloride, dodecyltrimethylammonium chloride, tetradecyltrimethylammonium chloride, cetyltrimethylammonium chloride, stearyltrimethylammonium chloride, alkyltrimethylammonium bromide, hexadecyltrimethylammonium bromide, benzyltrimethylammonium chloride, benzyltriethylammonium chloride, benzalkonium chloride, benzalkonium bromide, benzethonium chloride, dialkyl dimethylammonium chloride, didecyl dimethylammonium chloride, distearyl dimethylammonium chloride, monomethylamine hydrochloride, dimethylamine hydrochloride, trimethylamine hydrochloride, butylpyridinium chloride, dodecylpyridinium chloride, and cetylpyridinium chloride.

Examples of amphoteric surfactants include lauryl dimethylamino acetate betaine, stearyl dimethylamino acetate betaine, dodecylamino methyl dimethyl sulfopropyl betaine, octadecylamino methyl dimethyl sulfopropyl betaine, cocamidopropyl betaine, cocamidopropyl hydroxysultaine, 2-alkyl-N-carboxymethyl-N-hydroxyethyl imidazolinium betaine, sodium lauroyl glutamate, potassium lauroyl glutamate, lauroyl methyl-$\beta$-alanine, lauryl dimethylamine N-oxide, and oleyl dimethylamine N-oxide.

Examples of non-ionic surfactants include glycerol laurate, glycerol monostearate, sorbitan fatty acid esters, sucrose fatty acid esters, polyoxyethylene alkyl ethers, pentaethylene glycol monodododecyl ether, octaethylene glycol monododecyl ether, polyoxyethylene alkyl phenyl ether, octylphenol ethoxylate, nonylphenol ethoxylate, polyoxyethylene polyoxypropylene glycol, polyoxyethylene sorbitan fatty acid esters, polyoxyethylene hexitan fatty acid esters, sorbitan fatty acid esters polyethylene glycol, lauric acid diethanolamide, oleic acid diethanolamide, stearic acid diethanolamide, octyl glucoside, decyl glucoside, lauryl glucoside, cethanol, stearyl alcohol, and oleyl alcohol.

As non-ionic surfactants, water-soluble polymers having terminal hydrophobic groups may be also used other than the examples described above. Examples of water-soluble polymers having terminal hydrophobic groups include water-soluble polymers having nitrogen-containing functional groups and terminal hydrophobic groups. Unlike the surfactants of the related art, water-soluble polymers having nitrogen-containing functional groups and terminal hydrophobic groups have a surfactant performance due to the main chain portion (hydrophilic portion) having nitrogen-containing functional groups and the terminal hydrophobic group portion and are highly effective in improving the coating property. Thus, it is possible to impart an excellent coating property to a conductive composite without the use of other surfactants. Moreover, this water-soluble polymer does not include acids or bases and does not easily produce by-products due to hydrolysis, thus, for example, the adverse influence on the resist layer is particularly low.

Amide groups are preferable as the nitrogen-containing functional groups from the viewpoint of solubility.

Examples of terminal hydrophobic groups include alkyl groups, aralkyl groups, aryl groups, alkoxy groups, aralkyloxy groups, aryloxy groups, alkylthio groups, aralkylthio groups, arylthio groups, primary or secondary alkylamino groups, aralkylamino groups, and arylamino groups. Among the above, alkylthio groups, aralkylthio groups, and arylthio groups are preferable.

The number of carbon atoms of the terminal hydrophobic group is preferably 7 to 100, more preferably 7 to 50,

and particularly preferably 10 to 30.

The number of terminal hydrophobic groups in the water-soluble polymer is not particularly limited. In addition, when having two or more terminal hydrophobic groups in the same molecule, the terminal hydrophobic groups may be the same type or may be different types.

As a water-soluble polymer, a compound is preferable which has a main chain structure of a homopolymer of a vinyl monomer having a nitrogen-containing functional group or a copolymer of a vinyl monomer having a nitrogen-containing functional group and a vinyl monomer not having a nitrogen-containing functional group (other vinyl monomer) and which has hydrophobic groups at sites other than the repeating units forming the polymer.

Examples of vinyl monomers having nitrogen-containing functional groups include acrylamide and derivatives thereof and heterocyclic monomers having nitrogen-containing functional groups, among which examples having amide bonds are preferable. Examples thereof include acrylamide, N,N-dimethylacrylamide, N-isopropylacrylamide, N,N-diethylacrylamide, N,N-dimethylaminopropylacrylamide, t-butylacrylamide, diacetoneacrylamide, N,N'-methylenebisacrylamide, N-vinyl-N-methylacrylamide, N-vinylpyrrolidone, and N-vinylcaprolactam. Among the above, from the viewpoint of solubility, acrylamide, N-vinylpyrrolidone, and N-vinylcaprolactam are particularly preferable.

Other vinyl monomers are not particularly limited as long as copolymerization is possible with vinyl monomers having nitrogen-containing functional groups and examples thereof include styrene, acrylic acid, vinyl acetate, and long-chain $\alpha$-olefin.

The method of introducing terminal hydrophobic groups into water-soluble polymers is not particularly limited; however, usually, introduction by selecting a chain transfer agent during vinyl polymerization is convenient and preferable. In such a case, the chain transfer agent is not particularly limited as long as a group including a hydrophobic group such as an alkyl group, aralkyl group, aryl group, alkylthio group, aralkylthio group, or arylthio group is introduced at the terminal of the obtained polymer. For example, when obtaining a water-soluble polymer having an alkylthio group, an aralkylthio group, or an arylthio group as a terminal hydrophobic group, it is preferable to carry out vinyl polymerization using a chain transfer agent having hydrophobic groups corresponding to these terminal hydrophobic groups, for example, thiols, disulfides, and thioethers. Examples of such chain transfer agents include n-dodecyl mercaptan, t-dodecyl mercaptan, n-octyl mercaptan, 2-ethylhexyl mercaptan, and n-octadecyl mercaptan.

One of the above may be used alone or two or more may be used together in any ratio.

For example, as polymerization initiators used during vinyl polymerization, it is possible to use azobis-methylbutyronitrile and polymerization initiators having terminal hydrophobic groups.

Polymerization initiators having terminal hydrophobic groups include polymerization initiators having linear or branched-chain alkyl groups with 6 to 20 carbon atoms and not having cyano groups or hydroxy groups. Examples thereof include dilauroyl peroxide, 1,1,3,3-tetramethylbutylhydroperoxide, di-t-hexyl peroxide, di(2-ethylhexyl)peroxydicarbonate, 1,1,3,3-tetramethylbutylperoxyneodecanoate, and di(3,5,5-trimethylhexanoyl)peroxide. One of the above may be used alone or two or more may be used together in any ratio.

The main chain portion of the water-soluble polymer is water-soluble and has nitrogen-containing functional groups. The number of units (degree of polymerization) of the main chain portion is preferably 2 to 1000 in one molecule, more preferably 2 to 100, and particularly preferably 2 to 50. When the number of units of the main chain portion having nitrogen-containing functional groups is the upper limit value described above or less, the surfactant performance does not easily deteriorate.

The molecular weight ratio (mass average molecular weight of the main chain portion/mass average molecular weight of the terminal hydrophobic group portion) of the main chain portion in the water-soluble polymer and the terminal hydrophobic group portion is preferably 0.3 to 170.

In terms of the polyethylene glycol equivalent in GPC, the mass average molecular weight of the water-soluble polymer is preferably 100 to 1,000,000, more preferably 100 to 100,000, even more preferably 600 to 2,000, and particularly preferably 600 to 1,800. When the mass average molecular weight of the water-soluble polymer is the lower limit value described above or more, the coating property of the conductive composite is increased. On the other hand, when the mass average molecular weight of the water-soluble polymer is the upper limit value described above or less, the water solubility of the conductive composite is increased. In particular, when the mass average molecular weight of the water-soluble polymer is 600 and 1800, the balance between practical water solubility and coating property is excellent.

As the surfactant (B), among the above, in terms of a low influence on the resist layer, a non-ionic surfactant is preferable and a water-soluble polymer having terminal hydrophobic groups is particularly preferable among the above. Among water-soluble polymers having terminal hydrophobic groups, in particular, a compound represented by General Formula (7) (also referred to below as "compound (7)") and a compound represented by General Formula (8) (also referred to below as "compound (8)") are preferable. Any one of these compounds may be used alone or two or more may be used together in any ratio.

[Chem. 7]

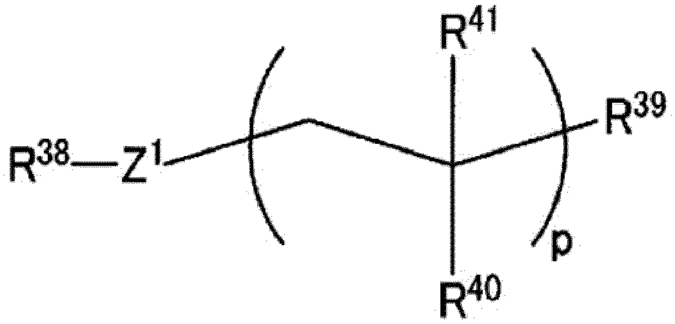

· · · (7)

In Formula (7),

$R^{38}$ represents a hydrogen atom, a linear or branched-chain alkyl group, an aralkyl group or an aryl group,
$R^{39}$ represents a hydrogen atom, an alkylthio group, an aralkylthio group, an arylthio group, or a hydrocarbon group,
$R^{40}$ represents a hydrophilic group,
$R^{41}$ represents a hydrogen atom or a methyl group,
$Z^1$ represents a single bond, -S-, -S(=O)-, -C(=O)-O-, or -O-, and
p is a number from 1 to 50.

However, $R^{38}$ and $R^{39}$ are never simultaneously hydrogen atoms.

[Chem. 8]

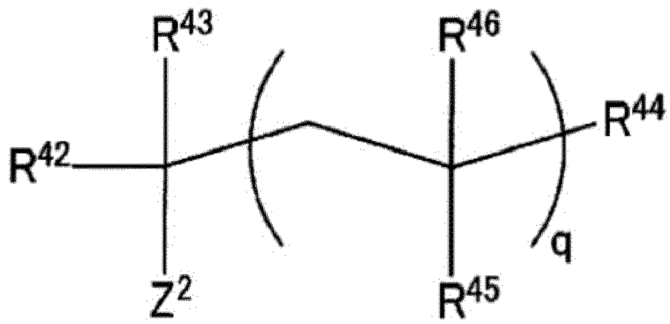

· · · (8)

In Formula (8),

$R^{42}$ and $R^{43}$ each independently represent a methyl or ethyl group,
$R^{44}$ represents a hydrogen atom, an alkylthio group, an aralkylthio group, an arylthio group, or a hydrocarbon group,
$R^{45}$ represents a hydrophilic group,
$R^{46}$ represents a hydrogen atom or a methyl group,
$Z^2$ represents a cyano group or a hydroxy group, and
q is a number from 1 to 50.

The number of carbon atoms of the alkyl group in $R^{38}$ is preferably 6 to 20.
The number of carbon atoms of the aralkyl group in $R^{38}$ is preferably 7 to 20.
The number of carbon atoms of the aryl group in $R^{38}$ is preferably 6 to 20.
Examples of the alkylthio group in $R^{39}$ and $R^{44}$ include a group in which a sulfur atom is bonded to a linear or branched-chain alkyl group with 1 to 20 carbon atoms.
Examples of the aralkylthio group in $R^{39}$ and $R^{44}$ include a group in which a sulfur atom is bonded to a linear or branched-chain aralkyl group with 7 to 20 carbon atoms.
Examples of the aryl group in $R^{39}$ and $R^{44}$ include a group in which a sulfur atom is bonded to a linear or branched-chain aryl group with 6 to 20 carbon atoms.
Examples of the hydrocarbon groups in $R^{39}$ and $R^{44}$ include linear or branched-chain alkyl groups having 1 to 20 carbon atoms, linear or branched-chain alkenyl groups having 1 to 20 carbon atoms, and linear or branched-chain

alkynyl groups having 1 to 20 carbon atoms.

The hydrophilic groups in $R^{40}$ and $R^{45}$ are derived from water-soluble vinyl monomers, which are the raw material monomers of water-soluble polymers. Here, water-soluble vinyl monomer indicates a vinyl monomer able to be mixed with water in any ratio. Examples of such water-soluble vinyl monomers include N-vinylpyrrolidone, 2-hydroxyethyl (meth)acrylate, (meth)acrylamide, N,N-dimethylacrylamide, acryloyl morpholine, and N-vinylformamide.

Examples of the compound (7) include a compound represented by General Formula (71) (also referred to below as "compound (71)").

[Chem. 9]

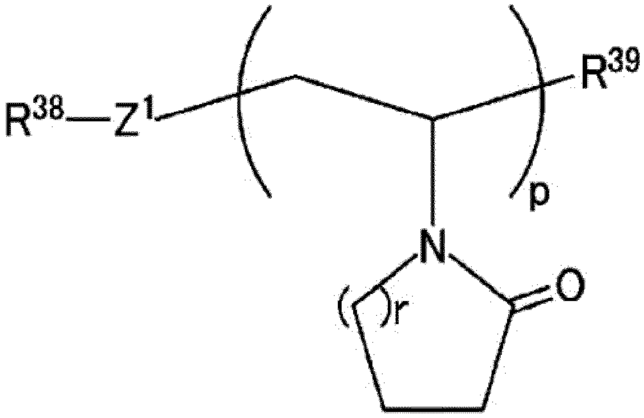

・・・(71)

In Formula (71),

$R^{38}$ represents a hydrogen atom, a linear or branched-chain alkyl group, an aralkyl group, or an aryl group,
$R^{39}$ represents a hydrogen atom, an alkylthio group, an aralkylthio group, an arylthio group, or a hydrocarbon group,
$Z^1$ represents a single bond, -S-, -S(=O)-, -C(=O)-O-, or -O-,
p is a number from 1 to 50, and
r is a number from 1 to 5.

However, $R^{38}$ and $R^{39}$ are never simultaneously hydrogen atoms.

Examples of the compound (8) include a compound represented by General Formula (81) (also referred to below as "compound (81)").

[Chem. 10]

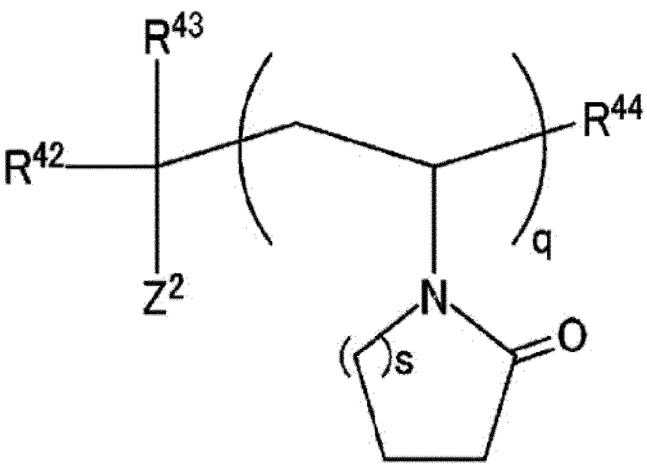

・・・(81)

In Formula (81),

$R^{42}$ and $R^{43}$ each independently represent a methyl or ethyl group,
$R^{44}$ represents a hydrogen atom, an alkylthio group, an aralkylthio group, an arylthio group, or a hydrocarbon group,
$Z^2$ represents a cyano group or a hydroxy group,
q is a number from 1 to 50, and
s is a number from 1 to 5.

<Solvent (C)>

The solvent (C) is not particularly limited beyond being a solvent able to dissolve the conductive polymer (A) and the surfactant (B). Examples thereof include water, organic solvents, and mixed solvents of water and organic solvents.

Examples of water include tap water, ion-exchanged water, pure water, and distilled water.

Examples of the organic solvent include the solvents exemplified as organic solvents as polymerization solvents in the method for producing the conductive polymer (A).

When a mixed solvent of water and an organic solvent is used as the solvent (C), the mass ratio of these solvents (water/organic solvent) is preferably 1/100 to 100/1 and more preferably 2/100 to 100/2.

<Optional Components>

The conductive composite may include components (optional components) other than the conductive polymer (A), the surfactant (B), and the solvent (C) as necessary.

Examples of optional components include basic compounds (D), polymer compounds (excluding the conductive polymer (A), the surfactant (B), and the basic compounds (D)), and additives.

The basic compounds (D) are not particularly limited beyond being compounds having basic properties and examples thereof include a quaternary ammonium compound (d-1), a basic compound (d-2), a basic compound (d-3), and a basic compound (d-4) described below.

Quaternary ammonium compound (d-1): A quaternary ammonium compound in which at least one of the four substituents bonded to the nitrogen atom is a hydrocarbon group with one or more carbon atoms.

Basic compound (d-2): A basic compound having one or more nitrogen atoms (excluding the quaternary ammonium compound (d-1) and the basic compound (d-3)).

Basic compound (d-3): A basic compound having a basic group and two or more hydroxy groups in the same molecule and a melting point of 30°C or higher.

Basic compound (d-4): An inorganic base.

In the quaternary ammonium compound (d-1), the nitrogen atom to which the four substituents are bonded is the nitrogen atom of the quaternary ammonium ion.

In the quaternary ammonium compound (d-1), examples of the hydrocarbon group bonded to the nitrogen atom of the quaternary ammonium ion include an alkyl group, an aralkyl group, or an aryl group.

Examples of the quaternary ammonium compound (d-1) include tetramethylammonium hydroxide, tetraethylammonium hydroxide, tetrapropylammonium hydroxide, tetrabutylammonium hydroxide, tetrapentylammonium hydroxide, tetrahexylammonium hydroxide, and benzyltrimethylammonium hydroxide.

Examples of the basic compound (d-2) include ammonia, pyridine, 4-dimethylaminopyridine, 4-dimethylaminomethylpyridine, 3,4-bis(dimethylamino)pyridine, picoline, triethylamine, 4-dimethylaminopyridine, 4-dimethylaminomethylpyridine, 3,4-bis(dimethylamino)pyridine, 1,5-diazabicyclo[4.3.0]-5-nonene (DBN), 1,8-diazabicyclo[5.4.0]-7-undecene (DBU), 1-(3-aminopropyl)-2-pyrrolidone, N-(3-aminopropyl)-ε-caprolactam, 1,5,7-triazabicyclo[4.4.0]deca-5-ene, 7-methyl-1,5,7-triazabicyclo[4.4.0]deca-5-ene, and derivatives thereof.

In the basic compound (d-3), examples of basic groups include basic groups defined as Arrhenius bases, Brønsted bases, Lewis bases, and the like. Specifically, examples thereof include ammonia. The hydroxy group may be in the -OH state or may be in a state of being protected by a protecting group. Examples of protecting groups include acetyl groups; silyl groups such as trimethylsilyl groups and t-butyldimethylsilyl groups; acetal-type protecting groups such as methoxymethyl groups, ethoxymethyl groups, and methoxyethoxymethyl groups; benzoyl groups, and alkoxide groups.

Examples of the basic compound (d-3) include 2-amino-1,3-propanediol, tris(hydroxymethyl)aminomethane, 2-amino-2-methyl-1,3-propanediol, 2-amino-2-ethyl-1,3-propanediol, 3-[N-tris(hydroxymethyl)methylamino]-2-hydroxypropanesulfonic acid, and N-tris(hydroxymethyl)methyl-2-aminoethanesulfonic acid.

Examples of the basic compound (d-4) include sodium hydroxide, potassium hydroxide, lithium hydroxide, rubidium hydroxide, cesium hydroxide, vanadium hydroxide, calcium hydroxide, and strontium hydroxide.

Any one of these basic compounds (D) may be used alone or two or more may be used together in any ratio.

As the basic compounds (D), compounds with an acid dissociation constant (pKa) at 25°C of 13 or higher and

a molecular weight of 200 or less are preferable.

When the acid dissociation constant of the basic compound (D) at 25°C is 13 or higher, it is possible to form stable salts with the acid groups of the conductive polymer (A), decomposition products of oxidizing agents, and basic compounds and there is a tendency for it to be possible to suppress film loss of the resist layer.

The upper limit value of the acid dissociation constant of the basic compound (D) is not particularly limited.

The acid dissociation constant is a value listed in "Chemistry Handbook, Fundamentals II" (edited by the Chemical Society of Japan, published by Maruzen on September 25, 1966).

When the molecular weight of the basic compound (D) is 200 or less, the influence of steric hindrance deriving from the basic compound (D) itself is reduced, such that it is possible to form stable salts with the acid groups of the conductive polymer (A), decomposition products of the oxidizing agent, and basic compounds and there is a tendency for it to be possible to suppress film loss of the resist layer.

The lower limit value of the molecular weight of the basic compound (B) is not particularly limited.

Examples of basic compounds with an acid dissociation constant at 25°C of 13 or higher and a molecular weight of 200 or less include organic bases such as 1,5,7-triazabicyclo[4.4.0]deca-5-ene (pKa = 26, molecular weight = 139.20), 7-methyl-1,5,7-triazabicyclo[4.4.0]deca-5-ene (pKa = 25, molecular weight = 153.23), tetramethylammonium hydroxide (molecular weight = 91.15), and tetraethylammonium hydroxide (molecular weight = 147.26); and inorganic bases such as lithium hydroxide (molecular weight = 23.95), sodium hydroxide (molecular weight = 39.99), potassium hydroxide (molecular weight = 56.10), rubidium hydroxide (molecular weight = 102.48), cesium hydroxide (molecular weight = 149.91), vanadium hydroxide (molecular weight = 171.34), calcium hydroxide (molecular weight = 74.09), and strontium hydroxide (molecular weight = 121.63). The pKa of the quaternary ammonium and inorganic bases at 25°C are all 13 or higher. Any one of these basic compounds may be used alone or two or more may be used together in any ratio.

Among the above, from the viewpoint of achieving both improving the conductivity and suppressing film loss, 1,5,7-triazabicyclo[4.4.0]deca-5-ene, 7-methyl-1,5,7-triazabicyclo[4.4.0]deca-5-ene and potassium hydroxide are more preferable, and potassium hydroxide is particularly preferable.

Examples of polymer compounds include polyvinyl alcohol derivatives such as polyvinyl formal and polyvinyl butyral and modified products thereof, starch and modified products thereof (starch oxide, phosphate esterified starch, cationized starch, and the like), cellulose derivatives (carboxymethyl cellulose, methylcellulose, hydroxypropyl cellulose, hydroxyethylcellulose, salts thereof, and the like), polyacrylamides such as polyacrylamide, poly(N-t-butylacrylamide), and polyacrylamidomethylpropanesulfonic acid, polyvinylpyrrolidone, polyacrylic acid (salt), polyethylene glycol, water-soluble alkyd resins, water-soluble melamine resins, water-soluble urea resins, water-soluble phenolic resins, water-soluble epoxy resins, water-soluble polybutadiene resins, water-soluble acrylic resins, water-soluble urethane resins, water-soluble acryl-styrene copolymer resins, water-soluble vinyl acetate-acrylic copolymer resins, water-soluble polyester resins, water-soluble styrene-maleic acid copolymerized resins, water-soluble fluororesins, and copolymers thereof.

Examples of additives include pigments, defoamers, UV absorbers, antioxidizing agents, heat resistance improvers, leveling agents, anti-sagging agents, matting agents, and preservatives.

<Contents>

The composition of the conductive composite depends on the critical micelle concentration of the surfactant (B).

Here, the critical micelle concentration is the minimum concentration required to function as a surfactant and the lower the critical micelle concentration, the higher the surfactant performance. It is possible to determine the critical micelle concentration by measuring the surface tension. Specifically, the surfactant (B) is gradually added to an aqueous medium, the surface tension at 25°C is measured, and the concentration of surfactant at which the surface tension does not decrease as the added amount of the surfactant (B) is increased is set as the critical micelle concentration. When the surfactant (B) is formed of a mixture of two or more types, the critical micelle concentration is determined in the mixture state.

Below, the surfactant (B) with a critical micelle concentration of less than 0.1% by mass is also referred to as a "surfactant (B1)" and the surfactant (B) with a critical micelle concentration of 0.1% by mass or more is referred to as a "surfactant (B2)".

(When Critical Micelle Concentration of Surfactant (B) in Conductive Composite is Less Than 0.1% By Mass)

When the content of the conductive polymer (A) is 0.01% by mass or more with respect to the total mass of the conductive composite, the conductivity of the formed conductive film tends to be excellent. The content is more preferably 0.05% by mass or more and even more preferably 0.1% by mass or more. When the content of the conductive polymer (A) is 5% by mass or less with respect to the total mass of the conductive composite, the conductive composite tends to have an excellent coating property. The content is more preferably 3% by mass or less and even more preferably 2% by mass or less.

It is possible to arbitrarily combine the upper limit and lower limit described above. For example, with respect to the total mass of the conductive composite, the content of the conductive polymer (A) is preferably 0.01 to 5% by mass, more preferably 0.05 to 3% by mass, and even more preferably 0.1 to 2% by mass.

The content of the conductive polymer (A) is preferably 99% by mass or less with respect to the total mass of the solid content of the conductive composite, since the film loss of the resist layer tends to decrease when the conductive composite is used as a resist coating material. The solid content of the conductive composite is the remainder of the conductive composite excluding the solvent (C). The solid content is more preferably 95% by mass or less, and even more preferably 90% by mass or less.

When the content of the conductive polymer (A) is in the range described above, there is an excellent balance between the coating property of the conductive composite and the conductivity of the conductive film formed from the conductive composite.

The content of the surfactant (B1) is 5 parts by mass or more with respect to 100 parts by mass of the conductive polymer (A).

When the content of the surfactant (B1) is the lower limit value or more, the surfactant (B1) is more easily localized on the object side when becoming a conductive film. In particular, when the object is a resist layer, the surface of the resist layer is hydrophobic, while the conductive polymer (A) is hydrophilic, thus, the surfactant (B1) is easily localized on the resist layer side. Since this localized surfactant (B1) plays the role of a barrier layer, even if acid groups are eliminated from the conductive polymer (A), it is possible to suppress the eliminated acid groups from migrating to objects such as the resist layer and to suppress film loss of the resist layer. In addition, it is also possible to suppress the migration of decomposition products of the oxidizing agent to the resist layer and to suppress film loss of the resist layer. In addition, the wettability of the conductive composite on the object is improved, which facilitates film formation. The content is preferably 8 parts by mass or more and more preferably 10 parts by mass or more.

The upper limit value of the content of the surfactant (B1) is not particularly limited and there is a tendency for the effect of preventing film loss to increase as the content of the surfactant (B1) increases. However, as the content of the surfactant (B1) increases, the content of the conductive polymer (A) in the conductive composite decreases and conductivity tends to decrease. Thus, considering the balance between prevention of film loss and conductivity, the content of the surfactant (B1) is preferably 1000 parts by mass or less with respect to 100 parts by mass of the conductive polymer (A). The content is more preferably 500 parts by mass or less and even more preferably 300 parts by mass or less.

It is possible to arbitrarily combine the upper limit and lower limit described above. For example, the content of the surfactant (B1) with respect to 100 parts by mass of the conductive polymer (A) is preferably 5 to 1000 parts by mass, more preferably 8 to 500 parts by mass, and even more preferably 10 to 300 parts by mass.

When the conductive composite of the present invention contains the solvent (C), the content of the solvent (C) with respect to the total mass of the conductive composite is preferably 1 to 99% by mass, more preferably 10 to 98% by mass, and even more preferably 50 to 98% by mass.

When the content of the solvent (C) is within the range described above, there is an excellent balance between the coating property of the conductive composite and the conductivity of the conductive film formed from the conductive composite.

When the conductive polymer (A) is used in a state of being purified by the ion exchange method and dissolved in a polymerization solvent or an aqueous medium (the conductive polymer (A) in this state is also referred to below as "conductive polymer solution"), the polymerization solvent or aqueous medium derived from the conductive polymer solution is also included in the content of the solvent (C) in the conductive composite.

(When Critical Micelle Concentration of Surfactant (B) in Conductive Composite is 0.1% by mass or more)

When the content of the conductive polymer (A) is 0.01% by mass or more with respect to the total mass of the conductive composite, the conductivity of the formed conductive film tends to be excellent. The content is more preferably 0.05% by mass or more and even more preferably 0.1% by mass or more. When the content of the conductive polymer (A) is 5% by mass or less with respect to the total mass of the conductive composite, the conductive composite tends to have an excellent coating property. The content is more preferably 3% by mass or less and even more preferably 2% by mass or less.

It is possible to arbitrarily combine the upper limit and lower limit described above. For example, with respect to the total mass of the conductive composite, the content of the conductive polymer (A) is preferably 0.01 to 5% by mass, more preferably 0.05 to 3% by mass, and even more preferably 0.1 to 2% by mass.

The content of the conductive polymer (A) is preferably 90% by mass or less with respect to the total mass of the solid content of the conductive composite, since the film loss of the resist layer tends to decrease when the conductive composite is used as a resist coating material. The content is more preferably 60% by mass or less and even more preferably 40% by mass or less.

When the content of the conductive polymer (A) is in the range described above, there is an excellent balance

between the coating property of the conductive composite and the conductivity of the conductive film formed from the conductive composite.

The content of the surfactant (B2) is more than 100 parts by mass with respect to 100 parts by mass of the conductive polymer (A). In other words, the content of the surfactant (B2) is an amount exceeding the content of the conductive polymer (A).

When the content of the surfactant (B2) is the lower limit value or more, that is, in excess of the conductive polymer (A), the surfactant (B2) is more likely to localize on the object side when becoming a conductive film. Since this localized surfactant (B2) plays the role of a barrier layer, even if acid groups are eliminated from the conductive polymer (A), it is possible to suppress the eliminated acid groups from migrating to objects such as the resist layer and to suppress film loss of the resist layer. In addition, it is also possible to suppress the migration of decomposition products of the oxidizing agent to the resist layer and to suppress film loss of the resist layer. In addition, the wettability of the conductive composite on the object is improved, which facilitates film formation. The content of the surfactant (B2) is preferably 110 parts by mass or more, more preferably 200 parts by mass or more, even more preferably 250 parts by mass or more, and particularly preferably 300 parts by mass or more.

The upper limit value of the content of the surfactant (B2) is not particularly limited and there is a tendency for the effect of preventing film loss to increase as the content of the surfactant (B2) increases. However, as the content of the surfactant (B2) increases, to that extent, the content of the conductive polymer (A) in the conductive composite decreases and the conductivity tends to decrease. Thus, considering the balance between prevention of film loss and conductivity, the content of the surfactant (B2) with respect to 100 parts by mass of the conductive polymer (A) is preferably 2000 parts by mass or less. The content is more preferably 1500 parts by mass or less, even more preferably 1000 parts by mass or less, and particularly preferably 800 parts by mass or less.

It is possible to arbitrarily combine the upper limit and lower limit described above. For example, the content of the surfactant (B2) with respect to 100 parts by mass of the conductive polymer (A) is preferably more than 100 parts by mass and 2000 parts by mass or less, more preferably 110 to 2000 parts by mass, even more preferably 200 to 1500 parts by mass, particularly preferably 250 to 1000 parts by mass, and most preferably 300 to 800 parts by mass.

When the conductive composite of the present invention contains the solvent (C), the content of the solvent (C) with respect to the total mass of the conductive composite is preferably 1 to 99% by mass, more preferably 10 to 98% by mass, and even more preferably 50 to 98% by mass.

When the content of the solvent (C) is within the range described above, there is an excellent balance between the coating property of the conductive composite and the conductivity of the conductive film formed from the conductive composite.

When the conductive composite of the present invention includes the basic compound (D), when the content of the basic compound (D) is 1 part by mass or more, even if the conductive polymer (A) includes acid groups, it is possible to sufficiently form salts with the acid groups of the conductive polymer (A) and oxidizing agents and the acid groups are not easily eliminated. In addition, the basic compound also sufficiently forms salts with the decomposition products of the oxidizing agent. Thus, the migration of acid groups and decomposition products of oxidizing agents to the resist layer is suppressed and it is possible to suppress the film loss of the resist layer. The content is more preferably 3 parts by mass or more, even more preferably 5 parts by mass or more, and particularly preferably 7 parts by mass or more.

When the content of the basic compound (D) is 50 parts by mass or less, it is possible to sufficiently secure the content of the conductive polymer (A) in the conductive composite, thus, it is possible to form a conductive film with favorable conductivity. In addition, when the conductive polymer (A) includes acid groups, the acid groups are moderately present in a free state without forming salts with the basic compound (D) in the conductive film, thus, it is possible to maintain favorable conductivity. The content is more preferably 40 parts by mass or less, even more preferably 35 parts by mass or less, and particularly preferably 27 parts by mass or less.

It is possible to arbitrarily combine the upper limit and lower limit described above. For example, the content of the basic compound (D) with respect to 100 parts by mass of the conductive polymer (A) is preferably 1 to 50 parts by mass, more preferably 3 to 40 parts by mass, even more preferably 5 to 35 parts by mass, and particularly preferably 7 to 27 parts by mass.

<Method for Producing Conductive Composite>

The conductive composite is obtained by mixing the conductive polymer (A) and the surfactant (B) with one or more of the optional components, including the solvent (C) and the basic compound (D) as necessary.

Since the conductive polymer (A) produced by the method for producing the conductive polymer (A) is in solid form after washing, the conductive composite may be obtained by mixing the conductive polymer (A) in solid form, the surfactant (B), and one or more optional components including the solvent (C) and the basic compound (D) as necessary.

When using the conductive polymer (A) further purified by the ion exchange method after washing, the conductive

polymer (A) after the ion exchange treatment is obtained in the conductive polymer solution state as described above. Therefore, the conductive composite may be prepared by adding the surfactant (B) and one or more optional components including the basic compound (D) as necessary to this conductive polymer solution, and may be further diluted with the solvent (C).

<Action and Effect>

It is possible for the conductive composite of the present invention to have excellent conductivity and to achieve a surface resistivity of 1 x $10^{10}$ [Ω/sq] or less and also to achieve 1 x $10^{9}$ [Ω/sq] or less.
It is possible to suitably use the conductive composite of the present invention as a resist coating material. That is, since the conductive polymer (A) and a specific amount of the surfactant (B) are included, when becoming a conductive film, the surfactant (B) is easily localized on the object side such as the base material and resist layer and this localized surfactant (B) plays the role of a barrier layer. Therefore, even if the conductive polymer (A) includes acid groups, it is difficult for the acid groups eliminated from the conductive polymer (A) and decomposition products of the oxidizing agent to migrate to the resist layer and it is possible to suppress film loss of the resist layer.
The thinner the film thickness of the resist layer, the greater the tendency to be influenced in a case of film loss.
However, according to the conductive composite of the present invention, it is possible to form a conductive film with which film loss in a resist layer is low. Thus, the conductive composite of the present invention is also suitable when forming a conductive film on the surface of a resist layer with a thin film thickness, specifically, a film thickness of 500 nm or less, preferably 200 nm or less.

<Uses>

It is possible to suitably use the conductive composite of the present invention for antistatic use in charged particle beam lithography and suitable use is also possible as a resist coating material. Specifically, it is possible to form a conductive film by coating the conductive composite of the present invention on the surface of the resist layer for a pattern formation method using a chemically amplified resist with a charged particle beam. That is, in a resist where a conductive film including the conductive composite is formed on the surface, this conductive film becomes an antistatic film of the resist layer.
In addition to the above, for example, it is also possible to use the conductive composite of the present invention as a material for capacitors, transparent electrodes, semiconductors, and the like.
A description will be given below of an example of a method for forming a resist pattern using the conductive composite of the present invention.

<Method for Forming Resist Pattern>

The method for forming a resist pattern of the present invention has a laminating step of forming a conductive film of the conductive composite of the present invention on the surface of the resist layer of a substrate having a resist layer formed of a chemically amplified resist on one side, and an exposure step of irradiating the substrate on which the conductive film of the conductive composite of the present invention is formed on the resist layer surface with a charged particle beam in a pattern shape from the conductive film side.
The resist layer formed of a chemically amplified resist may be a positive-type or a negative-type, as long as the resist layer has sensitivity to a charged particle beam. Formation is possible using a known chemically amplified resist composite.
For example, after the exposure step, a water rinsing step of removing the conductive film by rinsing with water and a developing step of developing the resist layer to form a resist pattern are performed as necessary.
When the resist layer is formed of a chemically amplified resist, a post-exposure bake (also referred to below as "PEB") step of heating is preferably performed after the exposure step and before the developing step.

(Laminating Step)

In the laminating step, a conductive film is formed on the surface of the resist layer on a substrate having a resist layer formed of a chemically amplified resist on one side.
The substrate is not particularly limited as long as the substrate has the effect of the present invention; however, for example, polyester resins such as polyethylene terephthalate (PET) and polybutylene terephthalate (PBT); polyolefin resins such as polyethylene and polypropylene; vinyl chloride; nylon; polystyrene; polycarbonate; epoxy resin; fluororesin; polysulfone; polyimide; polyurethane; phenol resin; silicone resin; molded products and films of various polymer compounds such as synthetic paper; paper; iron; glass; quartz glass; various wafers; aluminum; copper; zinc; nickel; stainless

steel; and substrates with various paints, photosensitive resins or the like coated on the surface thereof.

The shape of the substrate is not particularly limited and may be plate-like or a non-plate-like shape.

On one side of the substrate, a resist layer formed of a positive-type or a negative-type resist is provided.

The positive-type resist is not particularly limited as long as the resist has sensitivity to charged particle beams and it is possible to use any known resist. Chemically amplified resists containing an acid generator that generates acid when irradiated with charged particle beams and a polymer including a constituent unit having an acid decomposable group are preferable.

It is possible to form positive-type resist layers by known methods. For example, it is possible to form a positive-type resist layer by coating an organic solvent solution of the resist on one side of the substrate and carrying out heating (pre-baking) as necessary.

Negative resists are not particularly limited as long as the resist has sensitivity to charged particle beams and it is possible to use any known resist. Chemically amplified resists containing an acid generator that generates acid upon being irradiated with charged particle beams, a polymer that is soluble in a developing solution, and a cross-linking agent are preferable.

It is possible to form negative-type resist layers by known methods in the same manner as positive-type resist layers.

The conductive composite of the present invention is coated on the surface of the resist layer and dried to form a conductive film. As necessary, a heat treatment may be carried out after drying.

The method for coating the conductive composite of the present invention on the resist layer is not particularly limited other than having the effect of the present invention and examples thereof include methods including spin coating methods, spray coating methods, dip coating methods, roll coating methods, gravure coating methods, reverse coating methods, roll brushing methods, air knife coating methods, and curtain coating methods.

A drying temperature of less than 40°C is preferable. The drying time is preferably less than one hour.

For the heat treatment temperature, from the viewpoint of conductivity, a temperature range of 40°C to 250°C is preferable and a temperature range of 60°C to 200°C is more preferable. From the viewpoint of stability, the treatment time is preferably within one hour and more preferably within 30 minutes.

The laminating step obtains a laminate in which a substrate, a resist layer, and a conductive film are laminated in this order.

The film thickness of the resist layer is not particularly limited.

The film thickness of the conductive film is preferably 1 to 100 nm, more preferably 5 to 50 nm, and even more preferably 5 to 30 nm.

(Exposure Step)

The exposure step is a step of irradiating the resist layer, on which a conductive film of the conductive composite of the present invention is formed on the resist layer surface, with charged particle beams in a pattern shape. Specifically, the laminate is irradiated with charged particle beams from the conductive film side.

The exposure step forms a latent image on the resist layer between the substrate and the conductive film. When the resist layer is formed of a chemically amplified resist, acid is generated from the acid generator in the charged particle beam irradiation portion (exposed portion).

At this time, since a conductive film is provided on the surface of the resist layer, it is possible to ground the entire laminate from the conductive film and to prevent the entire laminate from being charged. Therefore, it is possible to suppress position shifting of electrons incident on the resist layer due to the influence of the charging and to form a latent image corresponding to the target resist pattern with high accuracy.

(PEB Step)

The PEB step is a step of heating (PEB) the resist layer after the exposure step. For example, the laminate is heated by a known heating unit such as a hot plate.

When the resist layer irradiated with charged particle beams in the exposure step is heated, in the case of a positive-type resist layer, the reaction caused by the action of the acid generated from the acid generator is accelerated in the charged particle beam irradiation portion (exposed portion) and the solubility in the developing solution increases. On the other hand, in the case of a negative-type resist layer, on the contrary, the solubility in the developing solution decreases.

Heating conditions vary depending on the resist, but in terms of the heat resistance of the conductive film, 200°C or lower and for one hour or less is preferable.

(Water Rinsing/Developing Step)

The water rinsing/developing step is a step of removing the conductive film by rinsing with water and developing the resist layer to form a resist pattern.
Since the conductive film is water-soluble, when water rinsing is performed, the conductive film is dissolved and removed.
Water rinsing refers to contact with an aqueous solution. Examples of aqueous solutions include water, water including at least one of a base and a basic salt, water including an acid, and a mixture of water and a water-soluble organic solvent.
When the positive-type resist layer is developed, the charged particle beam irradiation portions (exposed portions) of the positive-type resist layer are dissolved and removed and a resist pattern formed of the charged particle beam non-irradiation portions (unexposed portions) of the positive-type resist layer is formed.
On the other hand, when the negative-type resist layer is developed, in contrast to the case of a positive-type resist layer, the charged particle beam non-irradiation portions (unexposed portions) are dissolved and removed and a resist pattern formed of the charged particle beam irradiation portions (exposed portions) of the negative-type resist layer is formed.
It is possible to perform the water rinsing/developing step, for example, by the ($\alpha$) or ($\beta$) methods below.

Method ($\alpha$): An alkaline developing solution is used for rinsing and a resist layer is developed along with the removal of the conductive film.
Method ($\beta$): Only the conductive film is removed by rinsing and then the resist layer is developed with a developing solution.

The alkaline developing solution (aqueous alkaline solution) used in method ($\alpha$) is not particularly limited and it is possible to use any known alkaline developing solution. Examples thereof include an aqueous tetramethylammonium hydroxide solution.
It is possible to perform the water rinsing in method ($\beta$) using an aqueous solution that does not correspond to a developing solution, for example, water. It is possible to perform the development using an alkaline developing solution in the same manner as method ($\alpha$).
After the water rinsing/developing step, the substrate may be subjected to a rinsing treatment with pure water or the like, as necessary.
After the water rinsing/developing step or after the rinsing treatment, the substrate on which the resist pattern is formed may be heated (post-baked), as necessary.
In the method for forming a resist pattern of the present invention, a substrate having a resist pattern on one side is obtained and a step of etching with the resist pattern as a mask (etching step) is performed to obtain a substrate on which a pattern is formed.
When the resist pattern remains on the substrate after the etching step, there may further be a step of removing the resist pattern on the substrate by a release agent.

[Examples]

A description will be given below of the present invention using Examples, but the following Examples do not limit the scope of the present invention.

[Measurement/Evaluation Method]

<Measurement of Critical Micelle Concentration>

A measurement sample was prepared by adding the surfactant (B) to water and the surface tension of the obtained measurement sample at 25°C was measured based on the plate method (Wilhelmy method) using an automatic surface tension meter (Kyowa Interface Science Co., Ltd., "CBVP-Z type").
That is, a measuring element (platinum plate) was immersed in the measurement sample adjusted to 25°C and the surface tension was determined from the displacement when the measuring element sank into the measurement sample when the force (surface tension) of the measuring element being pulled by the measurement sample and the spring force fixing the measuring element were balanced.
The surface tension of the measurement sample was measured by adding the surfactant (B) to the water 0.01 to 1% by mass at a time and the concentration of the surfactant when the surface tension did not decrease by increasing the added amounts of the surfactant (B) was set as the critical micelle concentration.

<Evaluation of Conductivity>

2.0 mL of the conductive composite was added dropwise on a glass base material and coated by spinning under conditions of 2000 rpm for 60 seconds by a spin coater to cover the entire surface of the base material and form a film, then, a heat treatment was performed on a hot plate at 80°C for two minutes and a conductive film of approximately 30 nm thickness was formed on the base material to obtain a conductive body.

The surface resistivity [Ω/sq] of the conductive film was measured by the two-terminal method (distance between electrodes: 20 mm) using Hiresta UX-MCP-HT800 (manufactured by Mitsubishi Chemical Analytec Corporation).

<Evaluation by Film Loss Test>

(Measurement of Film Reduction Ratio)

A chemically amplified electron beam resist (abbreviated below as "resist") was used to measure the film reduction ratio of the resist layer according to the following procedures (1A) to (8A).

(1A) Formation of resist layer: On a 4-inch silicon wafer as a base material, a 3 μL resist was coated by spinning under conditions of 2000 rpm for 60 seconds by a spin coater to achieve a film thickness of approximately 60 nm and then pre-baking was performed on a hot plate at 130°C for three minutes to remove a solvent to form a resist layer on the base material.
(2A) Film thickness measurement of resist layer 1: A part of the resist layer formed on the base material was peeled off, the base material surface was set as a reference position, and an initial film thickness a [nm] of the resist layer was measured using a high-speed spectroscopic ellipsometer ("M-2000 D", manufactured by J.A. Woollam).
(3A) Formation of conductive film: 2 mL of a conductive composite was added dropwise to the resist layer and coated by spinning under conditions of 2000 rpm for 60 seconds by a spin coater to cover the entire surface of the resist layer, then, pre-baking was performed on a hot plate at 80°C for three minutes, the solvent was removed, and a conductive film with a thickness of approximately 30 nm was formed on the resist layer.
(4A) PEB treatment: The base material with the conductive film and resist layer laminated thereon was heated on a hot plate at 120°C for 20 minutes under an air atmosphere and the base material in this state was left in the air at room temperature (25°C) for 90 seconds.
(5A) Water rinsing: After rinsing the conductive film with 20 mL of water, water was removed from the surface of the resist layer by spinning at 2000 rpm for 60 seconds by a spin coater.
(6A) Developing: 20 mL of a developing solution formed of a 2.38% by mass tetramethylammonium hydroxide (TMAH) aqueous solution was added dropwise onto the surface of the resist layer. After being left for 60 seconds, spinning was carried out at 2000 rpm for 60 seconds by the spin coater, the developing solution was removed from the surface of the resist layer, and then spinning was maintained for 60 seconds to carry out drying.
(7A) Film thickness measurement of resist layer 2: After peeling a part of the resist layer within 5 mm from the portion where the resist layer was partially peeled in (2A), a film thickness b [nm] of the resist layer after development was measured using a stylus step meter.
(8A) Calculation of film reduction ratio: The film reduction ratio [%] was calculated from Equation (i).

$$\text{Film reduction ratio [\%]} = 100 - (b/a \times 100) \ldots \text{(i)}$$

[Production Example 1]

<Production of Conductive Polymer (A)>

To 100 mmol of 2-aminoanisole-4-sulfonic acid, 100 mmol of pyridine and 100 mL of water were added to obtain a monomer solution.

To the obtained monomer solution, an aqueous solution of 100 mmol of ammonium peroxodisulfate (oxidizing agent solution) was added dropwise at 10°C. After finishing the dropwise addition, stirring was further carried out at 25°C for 15 hours, then the temperature was increased to 35°C and stirred for another two hours to obtain a reaction liquid in which the reaction product was precipitated (polymerization step).

The obtained reaction liquid was filtered through a centrifugal filter, the precipitate (reaction product) was collected, and the reaction product was washed with 1 L of methanol and then dried. 20 g of the reaction product after drying was dissolved in 980 g of pure water and 1000 g of conductive polymer solution (A1-1) with a solid concentration of 2% by mass was obtained.

A column was filled with 500 mL of a cation exchange resin ("Amberlite IR-120B", manufactured by Organo Corporation), which was washed with ultrapure water. 1000 g of the conductive polymer solution (A1-1) was passed through this column at a rate of 50 mL/min (SV = 6) to obtain 900 g of a conductive polymer solution (A1-2) from which basic substances and the like were removed.
Next, 500 mL of an anion exchange resin ("Amberlite IRA410", manufactured by Organo Corporation) washed with ultrapure water was filled into the column.
900 g of the conductive polymer solution (A1-2) was passed through this column at a rate of 50 mL/min (SV = 6) to obtain 800 g of a conductive polymer solution (A1-3) from which basic substances and the like were removed.
When composition analysis of this conductive polymer solution (A1-3) was performed by ion chromatography, 80% or more of the remaining monomer, 99% or more of the sulfate ions, and 99% or more of the basic substances were removed. In addition, the result of measuring the heating residue was 2.0% by mass. That is, the solid concentration of the conductive polymer solution (A1-3) is 2.0% by mass.
One sverdrup (SV) is defined as $1 \times 10^6$ $m^3/s$ (1 GL/s).

[Production Example 2]

<Production of Surfactant (B)>

55 g (0.49 mol) of N-vinylpyrrolidone, 3 g (15.60 mmol) of azobis-methylbutyronitrile as a polymerization initiator, and 1 g (4.94 mmol) of n-dodecyl mercaptan as a chain transfer agent were stirred and dissolved in 100 mL of isopropyl alcohol to obtain a reaction solution. Thereafter, the reaction solution was added dropwise at a rate of 1 mL/min to 100 mL of isopropyl alcohol, which was heated in advance to 80°C, and dropwise polymerization was performed. Dropwise polymerization was performed while maintaining the temperature of the isopropyl alcohol at 80°C. After finishing the dropwise addition, the solution was aged at 80°C for another two hours and then left to cool. Thereafter, vacuum concentration was performed, the concentrate was dissolved in 30 mL of acetone, and a water-soluble polymer solution was obtained. The obtained water-soluble polymer solution was added to 1000 mL of n-hexane to form a white precipitate and the obtained precipitate was filtered off. The obtained water-soluble polymer was washed with n-hexane, dried, and 45 g of water-soluble polymer (B-1) in powder form was obtained.
When the obtained water-soluble polymer (B-1) was analyzed, the obtained water-soluble polymer (B-1) was a mixture of a compound (71) represented by General Formula (71-1), a compound (81) represented by General Formula (81-1), and a compound (81) represented by General Formula (81-2). The mass ratio thereof was compound (71):compound (81) = 10:90.
The critical micelle concentration of the water-soluble polymer (B-1) was 0.1% by mass.

[Chem. 11]

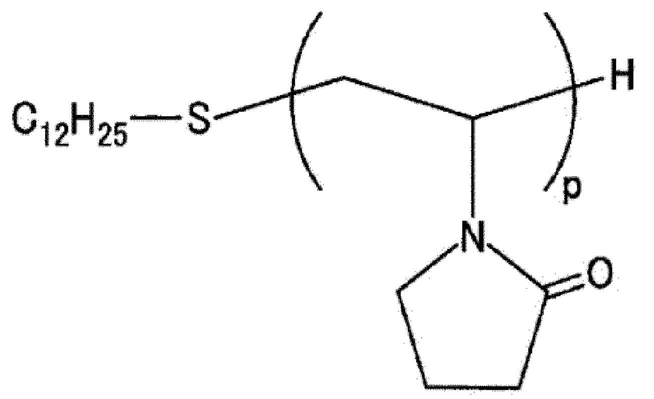

・・・(71-1)

[Chem. 12]

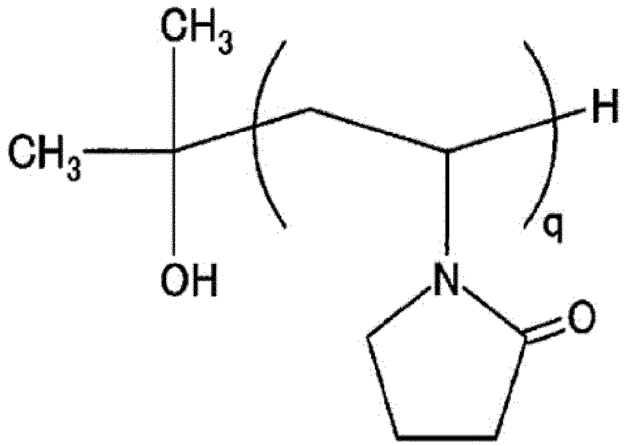

・・・(81−1)

[Chem. 13]

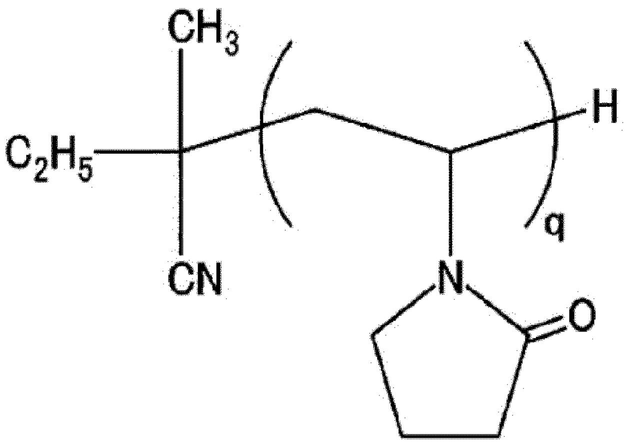

・・・(81−2)

[Production Example 3]

<Production of Surfactant (B)>

55 g (0.49 mol) of N-vinylpyrrolidone, 3 g (7.53 mmol) of dilauroyl peroxide as polymerization initiator, and 1 g (4.94 mmol) of n-dodecyl mercaptan as a chain transfer agent were stirred and dissolved in 100 mL of methyl isobutyl ketone to obtain a reaction solution. Thereafter, the reaction solution was added dropwise at a rate of 1 mL/min to 100 mL of isopropyl alcohol, which was heated in advance to 80°C, and dropwise polymerization was performed. Dropwise polymerization was performed while maintaining the temperature of the isopropyl alcohol at 80°C. After finishing the dropwise addition, the solution was aged at 80°C for another two hours and then left to cool. Thereafter, vacuum concentration was performed, the concentrate was dissolved in 30 mL of acetone, and a water-soluble polymer solution was obtained. The obtained water-soluble polymer solution was added to 1000 mL of n-hexane to form a white precipitate and the obtained precipitate was filtered off. The obtained water-soluble polymer was washed with n-hexane, dried, and 48 g of water-soluble polymer (B-2) in powder form was obtained.

When the obtained water-soluble polymer (B-2) was analyzed, the obtained water-soluble polymer (B-2) was a mixture of a compound (71) represented by General Formula (71-1) and a compound (81) represented by General Formula (81-1). The mass ratio thereof was compound (71):compound (81) = 40:60.

The critical micelle concentration of the water-soluble polymer (B-2) was 0.01% by mass.

[Example 1]

20 parts by mass (0.4 parts by mass in terms of solid content) of a conductive polymer solution (A1-3), 0.6 parts by mass of the water-soluble polymer (B-1), 4 parts by mass of isopropyl alcohol (IPA), and 75.4 parts by mass of water were mixed and a conductive composite was obtained. Table 1 shows the contents and the like of the conductive polymer (A), the surfactant (B), and the solvent (C) with respect to the total mass of the conductive composite.
The obtained conductive composites were evaluated for conductivity and tested for film loss. The results are shown in Table 1.

[Examples 2 to 4 / Comparative Examples 1 and 2]

Conductive composites were prepared in the same manner as in Example 1, except that the content of each component was changed such that the content of water-soluble polymer (B-1) with respect to 100 parts by mass of the conductive polymer (A) was the value shown in Table 1.
The obtained conductive composites were evaluated for conductivity and tested for film loss. The results are shown in Table 1.

[Table 1]

| | | | Example | | | | Comparative Example | |
|---|---|---|---|---|---|---|---|---|
| | | | 1 | 2 | 3 | 4 | 1 | 2 |
| Conductive composite | Conductive polymer (A) | Amount [parts by mass] | 0.4 | 0.3 | 0.2 | 0.1 | 1 | 0.6 |
| | Surfactant (B) | Type | B-1 | B-1 | B-1 | B-1 | - | B-1 |
| | | Critical micelle concentration [% by mass] | 0.1 | 0.1 | 0.1 | 0.1 | - | 0.1 |
| | | Amount [parts by mass] | 0.6 | 0.7 | 0.8 | 0.9 | 0 | 0.4 |
| | Solvent (C) | IPA [parts by mass] | 4 | 4 | 4 | 4 | 4 | 4 |
| | | Water [parts by mass] | 95 | 95 | 95 | 95 | 95 | 95 |
| Mass ratio (A:B) | | | 100:150 | 100:233.3 | 100:400 | 100:900 | 100:0 | 100:66.7 |
| Conductivity | | Surface resistivity [Ω/sq] | $3.1 \times 10^8$ | $4.1 \times 10^8$ | $7.9 \times 10^8$ | $1.3 \times 10^9$ | $7.3 \times 10^6$ | $6.8 \times 10^7$ |
| Film loss test | | Film reduction ratio [%] | 6.1 | 6.1 | 5.8 | 5.9 | 15.5 | 7 |

As is clear from Table 1, in the case of each Example, the surface resistivity was $1 \times 10^{10}$ [Ω/sq] or less and the film reduction ratio was 6.2% or less, and, according to the conductive composites obtained in each Example, it was possible to form conductive films having excellent conductivity and with which film loss in a resist layer is low.
On the other hand, in the case of the Comparative Examples, film loss easily occurred in the resist layer.

[Example 5]

45 parts by mass (0.9 parts by mass in terms of solid content) of the conductive polymer solution (A1-3), 0.1 parts by mass of the water-soluble polymer (B-2), 4 parts by mass of isopropyl alcohol (IPA), and 50.9 parts by mass

of water were mixed and a conductive composite was obtained. Table 2 shows the contents and the like of the conductive polymer (A), the surfactant (B), and the solvent (C) with respect to the total mass of the conductive composite.

The obtained conductive composites were evaluated for conductivity and tested for film loss. The results are shown in Table 2.

[Examples 6 and 7]

Conductive composites were prepared in the same manner as in Example 5, except that the content of each component was changed such that the content of the water-soluble polymer (B-2) with respect to 100 parts by mass of the conductive polymer (A) was the value shown in Table 2.

The obtained conductive composites were evaluated for conductivity and tested for film loss. The results are shown in Table 2.

[Comparative Example 3]

49.5 parts by mass (0.99 parts by mass in terms of solid content) of the conductive polymer solution (A1-3), 0.01 parts by mass of the water-soluble polymer (B-2), 4 parts by mass of isopropyl alcohol (IPA), and 46.49 parts by mass of water were mixed and a conductive composite was obtained. Table 2 shows the contents and the like of the conductive polymer (A), the surfactant (B), and the solvent (C) with respect to the total mass of the conductive composite.

The obtained conductive composites were evaluated for conductivity and tested for film loss. The results are shown in Table 2.

[Table 2]

| | | | Example | | | Comparative Example |
|---|---|---|---|---|---|---|
| | | | 5 | 6 | 7 | 3 |
| Conductive composite | Conductive polymer (A) | Amount [parts by mass] | 0.9 | 0.7 | 0.5 | 0.99 |
| | Surfactant (B) | Type | B-2 | B-2 | B-2 | B-2 |
| | | Critical micelle concentration [% by mass] | 0.01 | 0.01 | 0.01 | 0.01 |
| | | Amount [parts by mass] | 0.1 | 0.3 | 0.5 | 0.01 |
| | Solvent (C) | IPA [parts by mass] | 4 | 4 | 4 | 4 |
| | | Water [parts by mass] | 95 | 95 | 95 | 95 |
| Mass ratio (A:B) | | | 100:11.1 | 100:42.9 | 100:100 | 100:1.0 |
| Conductivity | | Surface resistivity [Ω/sq] | $6.4 \times 10^6$ | $3.2 \times 10^7$ | $1.0 \times 10^8$ | $2.7 \times 10^6$ |
| Film loss test | | Film reduction ratio [%] | 5.6 | 4.3 | 3.9 | 7.9 |

As is clear from Table 2, in the case of each Example, the surface resistivity was $1 \times 10^{10}$ [Ω/sq] or less and the film reduction ratio was 6.2% or less, and, according to the conductive composites obtained in each Example, it was possible to form conductive films having excellent conductivity and with which film loss in a resist layer is low. In particular, it was shown that, by using the water-soluble polymer (B-2) with a critical micelle concentration of 0.01% by mass, the effect of preventing film loss of the resist layer was sufficiently obtained, even with a small amount.

[Example 8]

18 parts by mass (0.36 parts by mass in terms of solid content) of the conductive polymer solution (A1-3), 0.55 parts by mass of the water-soluble polymer (B-1), 4 parts by mass of isopropyl alcohol (IPA), 0.09 parts by mass of 1,5,7-triazabicyclo[4.4.0]deca-5-ene (TBD), and 77.36 parts by mass of water were mixed and a conductive composite was obtained. Table 3 shows the contents and the like of the conductive polymer (A), the surfactant (B), the solvent (C), and the basic compound (D) with respect to the total mass of the conductive composite.

The obtained conductive composites were evaluated for conductivity and tested for film loss. The results are shown in Table 3.

[Example 9]

18 parts by mass (0.36 parts by mass in terms of solid content) of the conductive polymer solution (A1-3), 0.6 parts by mass of the water-soluble polymer (B-1), 4 parts by mass of isopropyl alcohol (IPA), 0.04 parts by mass of potassium hydroxide (KOH), and 77.36 parts by mass of water were mixed and a conductive composite was obtained. Table 3 shows the contents and the like of the conductive polymer (A), the surfactant (B), the solvent (C), and the basic compound (D) with respect to the total mass of the conductive composite.

The obtained conductive composites were evaluated for conductivity and tested for film loss. The results are shown in Table 3.

[Table 3]

| | | | Example | |
|---|---|---|---|---|
| | | | 8 | 9 |
| Conductive composite | Conductive polymer (A) | Amount [parts by mass] | 0.36 | 0.36 |
| | Surfactant (B) | Type | B-1 | B-1 |
| | | Critical micelle concentration [% by mass] | 0.1 | 0.1 |
| | | Amount [parts by mass] | 0.55 | 0.6 |
| | Solvent (C) | IPA [parts by mass] | 4 | 4 |
| | | Water [parts by mass] | 95 | 95 |
| | Basic compound (D) | Type | TBD | KOH |
| | | pKa | 26 | > 13 |
| | | Molecular weight | 136 | 56 |
| | | Amount [parts by mass] | 0.09 | 0.04 |
| Mass ratio (A:B) | | | 100:152.8 | 100:166.7 |
| Conductivity | | Surface resistivity [Ω/sq] | $8.2 \times 10^8$ | $7.1 \times 10^7$ |
| Film loss test | | Film reduction ratio [%] | 3.6 | 4.1 |

The abbreviations in Table 3 are as follows.

- TBD: 1,5,7-triazabicyclo[4.4.0]deca-5-ene (pKa = 26, molecular weight = 136).
- KOH: Potassium hydroxide (pKa>13, molecular weight=56).

As is clear from Table 3, in the case of each Example, the surface resistivity was $1x10^{10}$ [Ω/sq] or less and the film reduction ratio was 6.2% or less, and, according to the conductive composites obtained in each Example, it was possible to form conductive films having excellent conductivity and with which film loss in a resist layer is low.

[Industrial Applicability]

The conductive composite of the present invention, for example, is able to form a conductive film with which film loss in a resist layer is low when formed on the resist layer and patterned using charged particle beams and is useful for antistatic use during charged particle beam lithography.

## Claims

**1.** A conductive composite comprising:

a conductive polymer; and
a surfactant,
wherein a critical micelle concentration of the surfactant is less than 0.1% by mass and a content of the surfactant is 5 parts by mass or more with respect to 100 parts by mass of the conductive polymer.

**2.** The conductive composite according to Claim 1,
wherein the content of the surfactant is 10 parts by mass or more with respect to 100 parts by mass of the conductive polymer.

**3.** A conductive composite comprising:

a conductive polymer; and
a surfactant,
wherein a critical micelle concentration of the surfactant is 0.1% by mass or more and a content of the surfactant is more than 100 parts by mass with respect to 100 parts by mass of a content of the conductive polymer.

**4.** The conductive composite according to Claim 3,
wherein the content of the surfactant is 110 parts by mass or more with respect to 100 parts by mass of the conductive polymer.

**5.** The conductive composite according to any one of Claims 1 to 4, wherein the surfactant is a water-soluble polymer having a terminal hydrophobic group.

**6.** The conductive composite according to any one of Claims 1 to 5, further comprising:
a basic compound.

**7.** The conductive composite according to Claim 6,
wherein an acid dissociation constant of the basic compound at 25°C is 13 or more, a molecular weight of the basic compound is 200 or less, and a content of the basic compound is 1 to 50 parts by mass with respect to 100 parts by mass of the conductive polymer.

**8.** The conductive composite according to any one of Claims 1 to 7, wherein the conductive polymer has an acid group.

**9.** The conductive composite according to any one of Claims 1 to 8, wherein a surface resistivity is $1 \times 10^{10}$ [Ω/sq] or less.

**10.** A resist coating material comprising:
the conductive composite according to any one of Claims 1 to 9.

**11.** A resist,
wherein a conductive film including the conductive composite according to any one of Claims 1 to 9 is formed on a surface.

**12.** A method for forming a resist pattern, the method comprising:

a laminating step of forming a conductive film including the conductive composite according to any one of Claims 1 to 9 on a surface of a resist layer of a substrate having the resist layer formed of a chemically amplified resist on one side; and

an exposure step of irradiating the substrate on which the conductive film is formed with a charged particle beam in a pattern shape from a conductive film side.

**INTERNATIONAL SEARCH REPORT**

International application No. PCT/JP2021/003062

A. CLASSIFICATION OF SUBJECT MATTER
C08L 101/12(2006.01)i; G03F 7/20(2006.01)i; H01B 1/20(2006.01)i; H01L 21/027(2006.01)i
FI: C08L101/12; G03F7/20 521; H01L21/30 541P; G03F7/20 504; G03F7/20 506; H01B1/20 A

According to International Patent Classification (IPC) or to both national classification and IPC

B. FIELDS SEARCHED

Minimum documentation searched (classification system followed by classification symbols)
C08L101/12; G03F7/20; H01B1/20; H01L21/027

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)
CAplus/REGISTRY (STN)

C. DOCUMENTS CONSIDERED TO BE RELEVANT

| Category* | Citation of document, with indication, where appropriate, of the relevant passages | Relevant to claim No. |
|---|---|---|
| X<br>A | WO 2014/006821 A1 (SHIN-ETSU POLYMER CO., LTD.) 09 January 2014 (2014-01-09) claims 1, 4, 7, 8, paragraphs [0010], [0033], examples | 1-4, 8-12<br>5-7 |
| X<br>A | WO 2014/017540 A1 (MITSUBISHI RAYON CO., LTD.) 30 January 2014 (2014-01-30) claims 1-21, paragraphs [0012], [0017], [0145], examples | 3-12<br>1, 2 |
| X<br>A | WO 2019/146715 A1 (MITSUBISHI CHEMICAL CORPORATION) 01 August 2019 (2019-08-01) claims 1, 2, 4-8, paragraphs [0004], [0024], [0069], [0079], [0080], [0083], [0091], [0114], [0116], [0133], [0171] | 1, 2, 5-12<br>3, 4 |
| X<br>A | CN 106953066 A (DONGGUAN YONGBANG NEW ENERGY TECHNOLOGY CO. LTD.) 14 July 2017 (2017-07-14) examples | 1-4, 8<br>5-7, 9-12 |

☒ Further documents are listed in the continuation of Box C.　☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search: 17 March 2021 (17.03.2021)

Date of mailing of the international search report: 30 March 2021 (30.03.2021)

Name and mailing address of the ISA/
Japan Patent Office
3-4-3, Kasumigaseki, Chiyoda-ku,
Tokyo 100-8915, Japan

Authorized officer

Telephone No.

Form PCT/ISA/210 (second sheet) (January 2015)

**INTERNATIONAL SEARCH REPORT**

International application No.
PCT/JP2021/003062

C (Continuation). DOCUMENTS CONSIDERED TO BE RELEVANT

| Category* | Citation of document, with indication, where appropriate, of the relevant passages | Relevant to claim No. |
|---|---|---|
| A | ジェミニ型界面活性剤を用いた使用感に優れた耐水性 O/W エマルジョンの調製, J. Soc. Cosmet. Chem. Jpn vol. 51, no. 1, 2017, page 9, abstract, ("Preparation of Oil-in-Water Emulsion with a Good Texture of Use and Waterproofness Using the Gemini Surfactant") | 1-12 |
| A | CN 102993413 A (DONGHUA UNIVERSITY) 27 March 2013 (2013-03-27) | 1-12 |

Form PCT/ISA/210 (continuation of second sheet) (January 2015)

**INTERNATIONAL SEARCH REPORT**
Information on patent family members

International application No.
PCT/JP2021/003062

| Patent Documents referred in the Report | Publication Date | Patent Family | Publication Date |
|---|---|---|---|
| WO 2014/006821 A1 | 09 Jan. 2014 | US 2015/0140492 A1 claims 9, 13, 22-28, paragraphs [0015], [0047], examples<br>EP 2868698 A1<br>KR 10-2015-0035815 A | |
| WO 2014/017540 A1 | 30 Jan. 2014 | US 2015/0132537 A1 claims 1-21, paragraphs [0024], [0042], [0378], examples<br>KR 10-2014-0134310 A | |
| WO 2019/146715 A1 | 01 Aug. 2019 | (Family: none) | |
| CN 106953066 A | 14 Jul. 2017 | (Family: none) | |
| CN 102993413 A | 27 Mar. 2013 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2020012623 A
- JP H7324132 A
- JP 2011219680 A
- JP 2017171940 A
- JP S61197633 A
- JP S6339916 A
- JP H1301714 A
- JP H5504153 A
- JP H5503953 A
- JP H432848 A
- JP H4328181 A
- JP H6145386 A
- JP H656987 A
- JP H5226238 A
- JP H5178989 A
- JP H6293828 A
- JP H7118524 A
- JP H632845 A
- JP H687949 A
- JP H6256516 A
- JP H741756 A
- JP H748436 A
- JP H4268331 A
- JP 2014065898 A


### Non-patent literature cited in the description


- Chemistry Handbook, Fundamentals II. Maruzen, 25 September 1966